# EUROPEAN PATENT APPLICATION

(11) **EP 4 576 976 A1**
(43) Date of publication of application: **25.06.2025**
(21) Application number: 24218081.8
(22) Date of filing: 06.12.2024
(51) Int. Cl.: H10B 12/00, H10D 30/67

(54) **SEMICONDUCTOR DEVICE**

(30) Priority: 20.12.2023 KR 20230187518
(71) Applicant: Samsung Electronics Co., Ltd., Suwon-si, Gyeonggi-do 16677 (KR)
(72) Inventor: PARK, Sungjoon, Suwon-si, Gyeonggi-do 16677 (KR); TERAI, Masayuki, Suwon-si, Gyeonggi-do 16677 (KR)
(74) Representative: Kuhnen & Wacker Patent- und Rechtsanwaltsbüro PartG mbB

(57) **Abstract**

Provided is a semiconductor device (100) including a lower conductive line (BL) extending in a first horizontal direction (X) on a substrate (102), an isolating insulation pattern (114) extending in a second horizontal direction (Y) perpendicular to the first horizontal direction (X) on the lower conductive line (BL), a mold line pattern (120a) on the isolating insulation pattern (114), a pair of upper conductive lines (WL1, WL2) each having an inner wall in contact with a sidewall of the mold line pattern (120a) and a bottom surface in contact with a top surface of the isolating insulation pattern (114) and linearly extending in the second horizontal direction (Y), a gate dielectric layer (144) covering a top surface of the mold line pattern (120a) and outer walls of the pair of upper conductive lines (WL1, WL2), and a channel structure (156) contacting the lower conductive line (BL) and facing a first upper conductive line (WL1) from among the pair of upper conductive lines (WL1, WL2) with the gate dielectric layer (144) therebetween.

## Description

### BACKGROUND

The inventive concept relates to a semiconductor device, and more particularly, to a semiconductor device including a channel structure.

Due to the development of the electronic technology, down-scaling of semiconductor devices is rapidly progressing. Thus, a transistor with a channel layer including an oxide semiconductor material has been proposed to reduce a leakage current through a channel region.

### SUMMARY

Aspects of the inventive concept provide a semiconductor device with improved reliability.

According to an aspect of the inventive concept, there is provided a semiconductor device including a lower conductive line extending in a first horizontal direction on a substrate, an isolating insulation pattern extending in a second horizontal direction perpendicular to the first horizontal direction on the lower conductive line, a mold line pattern extending in the second horizontal direction on the isolating insulation pattern, a pair of upper conductive lines each having an inner wall in contact with a corresponding sidewall of the mold line pattern and a bottom surface in contact with a top surface of the isolating insulation pattern and linearly extending in the second horizontal direction, a gate dielectric layer covering a top surface of the mold line pattern and outer walls of the pair of upper conductive lines and linearly extending in the second horizontal direction, and a channel structure contacting the lower conductive line and facing a first upper conductive line from among the pair of upper conductive lines with the gate dielectric layer therebetween.

According to another aspect of the inventive concept, there is provided a semiconductor device including a plurality of bit lines extending lengthwise in a first horizontal direction and spaced apart from each other in a second horizontal direction perpendicular to the first horizontal direction, a plurality of isolating insulation patterns extending lengthwise in the second horizontal direction on the plurality of bit lines and spaced apart from each other in the first horizontal direction, a plurality of gate composite structures extending parallel to each other in the second horizontal direction on the plurality of isolating insulation patterns and each including a mold structure extending in the second horizontal direction, a first word line and a second word line respectively covering corresponding side walls of the mold structure and extending in the second horizontal direction, and a gate dielectric layer covering the mold structure, the first word line, and the second word line, a plurality of channel structures spaced apart from each other in the second horizontal direction between a first gate composite structure and a second gate composite structure adjacent to each other from among the plurality of gate composite structures, each contacting one bit line from among the plurality of bit lines, and respectively facing the second word line of the first gate composite structure and the first word line of the second gate composite structure, and a gap-fill insulation structure that fills a space between the first gate composite structure and the second gate composite structure and covers the first gate composite structure, the second gate composite structure, and the plurality of channel structures, wherein each of the first word line and the second word line includes an inner wall in contact with the mold structure and an outer wall in contact with the gate dielectric layer, and an upper portion of the outer wall has a curved shape convex toward the gate dielectric layer.

According to another aspect of the inventive concept, there is provided a semiconductor device including a substrate having a cell array region and an interface region surrounding the cell array region in a plan view, a peripheral circuit structure disposed on the substrate and including a plurality of peripheral circuits, a lower conductive line extending in a first horizontal direction in the cell array region on the peripheral circuit structure and electrically connected to the plurality of peripheral circuits, an isolating insulation pattern extending in a second horizontal direction on the lower conductive line and disposed in portions of the cell array region and the interface region, a mold line pattern extending in the second horizontal direction on the isolating insulation pattern, a pair of upper conductive lines each having an inner wall in contact with a corresponding sidewall of the mold line pattern and a bottom surface in contact with a top surface of the isolating insulation pattern and linearly extending in the second horizontal direction, a gate dielectric layer covering a top surface of the mold line pattern and outer walls of the pair of upper conductive lines and linearly extending in the second horizontal direction, a channel structure contacting the lower conductive line and facing a first upper conductive line from among the pair of upper conductive lines with the gate dielectric layer therebetween, a gap-fill insulation structure covering the gate dielectric layer and the channel structure, a conductive contact pattern penetrating through a portion of the gap-fill insulation structure and contacting a topmost surface of the channel structure in the cell array region, and a word line contact pattern penetrating through a portion of the gap-fill insulation structure and contacting the first upper conductive line in the interface region.

### BRIEF DESCRIPTION OF THE DRAWINGS

Embodiments of the inventive concept will be more clearly understood from the following detailed description taken in conjunction with the accompanying drawings in which:
FIG. 1 is a perspective view of a semiconductor device according to embodiments;
FIG. 2 is a plan layout diagram showing a partial configuration of the semiconductor device in a region "EXA1" in FIG. 1;
FIG. 3A is a cross-sectional view taken along a line X1-X1' of FIG. 2;
FIG. 3B is a cross-sectional view taken along a line X2-X2' of FIG. 2;
FIG. 3C is a cross-sectional view taken along a line Y1-Y1' of FIG. 2;
FIG. 4A is an enlarged cross-sectional view of a region "EXB 1" in FIG. 3A;
FIG. 4B is an enlarged cross-sectional view of a region "EXB2" in FIG. 3B;
FIG. 5A is a cross-sectional view of a semiconductor device according to some other embodiments;
FIG. 5B is a cross-sectional view of a semiconductor device according to some other embodiments;
FIG. 5C is a cross-sectional view of a semiconductor device according to some other embodiments;
FIG. 5D is a cross-sectional view of a semiconductor device according to some other embodiments;
FIG. 6 is a cross-sectional view of a semiconductor device according to some other embodiments; and
FIGS. 7A to 16B are diagrams illustrating a method of manufacturing a semiconductor device according to embodiments, according to a process sequence, wherein FIGS. 7A, 8A, 12A, 14A, 15A, and 16A are plan layout diagrams showing some configurations according to a process sequence to describe the method of manufacturing the semiconductor device, and FIGS. 7B, 8B, 9, 10, 11, 12B, 13, 14B, 15B, and 16B are cross-sectional views of a portion corresponding to a line X1-X1' of FIG. 2, according to the process sequence.

### DETAILED DESCRIPTION OF THE EMBODIMENTS

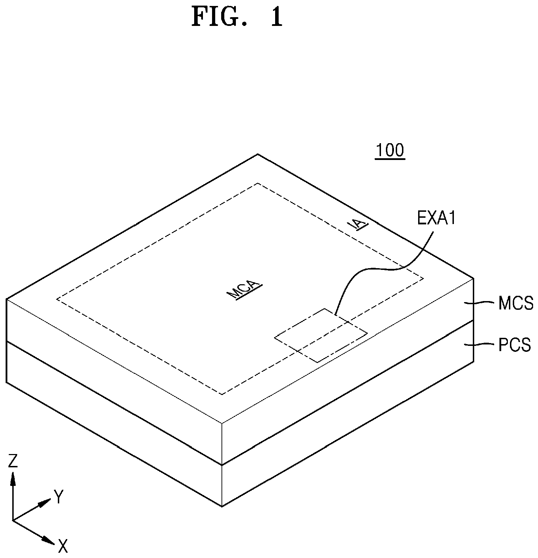

FIG. 1 is a perspective view of a semiconductor device 100 according to embodiments.

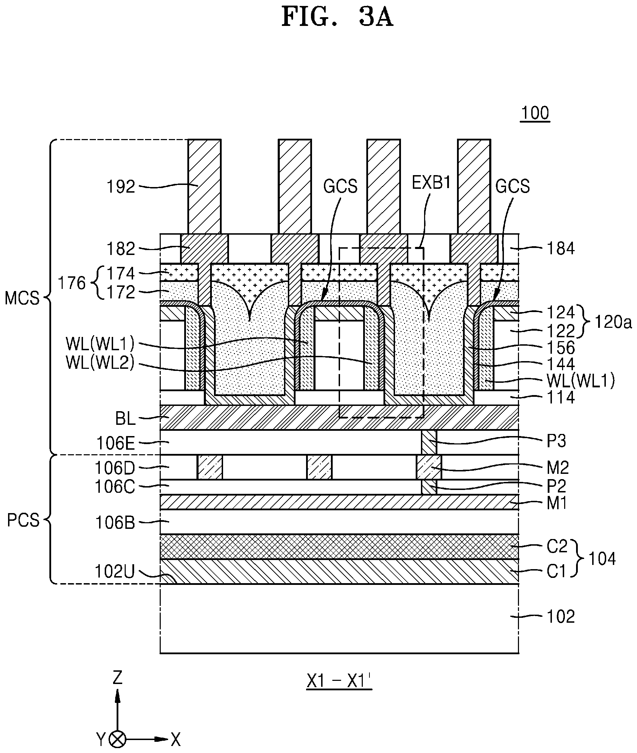

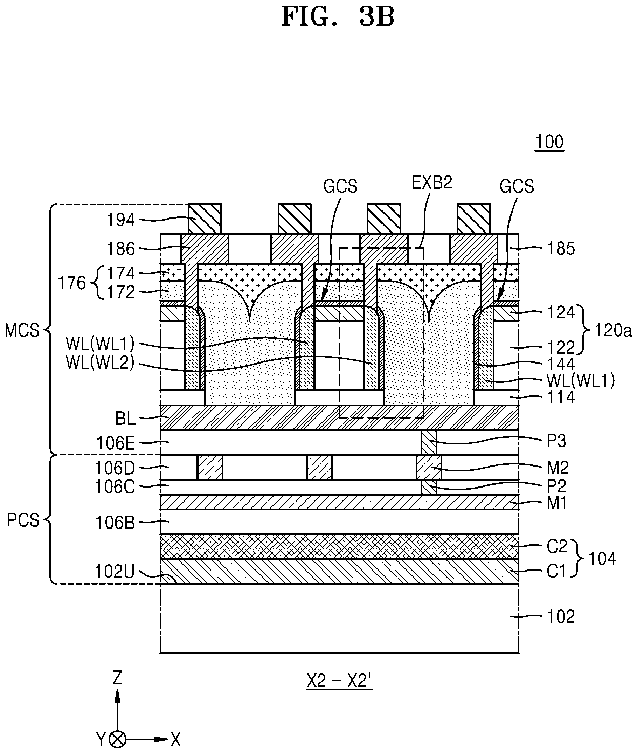

Referring to FIG. 1, the semiconductor device 100 may include a memory cell structure MCS and a peripheral circuit structure PCS arranged at different vertical levels. The peripheral circuit structure PCS and the memory cell structure MCS may overlap each other in a vertical direction. For example, the memory cell structure MCS may be disposed on the peripheral circuit structure PCS as shown in FIG. 1, and the semiconductor device 100 may have a cell-over-periphery (COP) structure. In a plan view, the memory cell structure MCS may include a memory cell array region MCA in which memory cells are arranged and an interface region IA surrounding the memory cell array region MCA. According to some embodiments, the peripheral circuit structure PCS may include a peripheral circuit of the semiconductor device 100. For example, the peripheral circuit structure PCS may include a peripheral circuit 104 (refer to FIGS. 3A and 3B) for transmitting signals and/or power to a memory cell array of the memory cell structure MCS. In example embodiments, the peripheral circuit 104 may configure various circuits such as a command decoder, control logic, an address buffer, a row decoder, a column decoder, a sense amplifier, and a data input/output circuit.

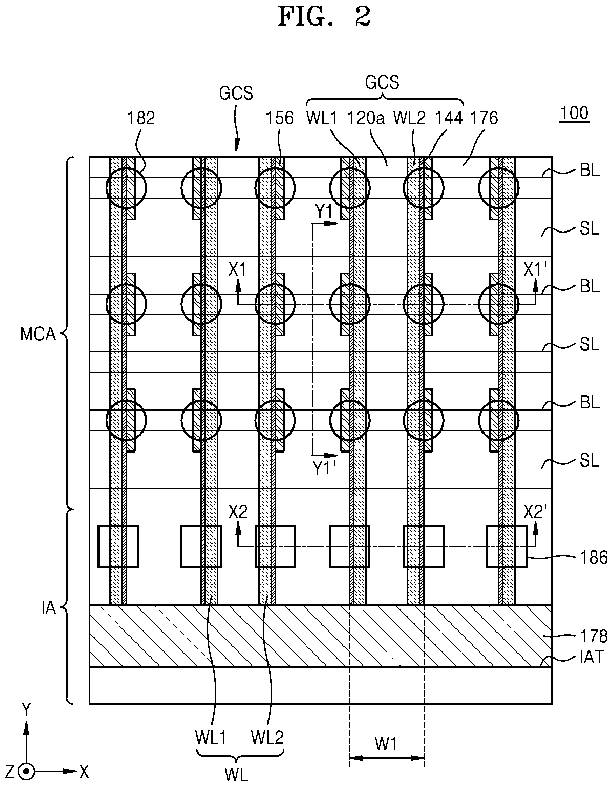

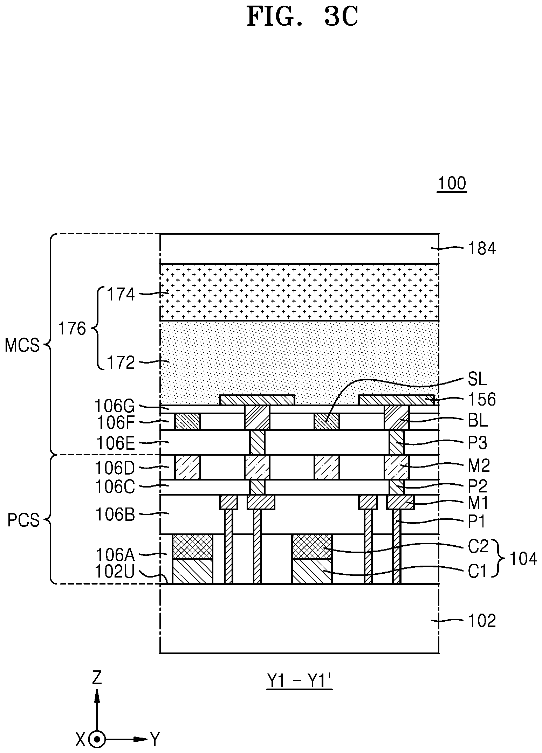

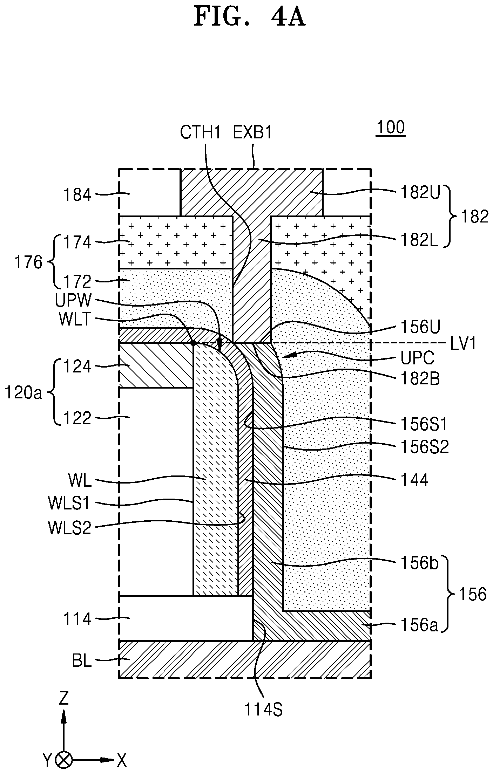

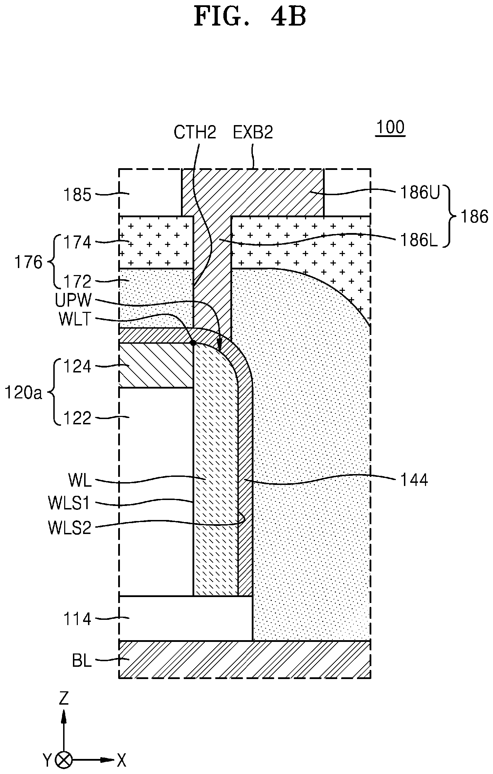

FIG. 2 is a plan layout diagram showing a partial configuration of the semiconductor device 100 in a region "EXA1" in FIG. 1. FIG. 3A is a cross-sectional view taken along a line X1-X1' of FIG. 2. FIG. 3B is a cross-sectional view taken along a line X2-X2' of FIG. 2. FIG. 3C is a cross-sectional view taken along a line Y1-Y1' of FIG. 2. FIG. 4A is an enlarged cross-sectional view of a region "EXB 1" in FIG. 3A. FIG. 4B is an enlarged cross-sectional view of a region "EXB2" in FIG. 3B.

Referring to FIGS. 2 to 3B, the semiconductor device 100 may include the peripheral circuit structure PCS and a memory cell structure MCS sequentially stacked on a substrate 102. The memory cell structure MCS may include a plurality of bit lines BL and a plurality of shielding structures SL arranged on the peripheral circuit structure PCS.

According to embodiments, the substrate 102 may include silicon, e.g., monocrystalline silicon, polycrystalline silicon, or amorphous silicon. According to other embodiments, the substrate 102 may include at least one selected from among Ge, SiGe, SiC, GaAs, InAs, and InP. According to embodiments, the substrate 102 may include conductive regions, e.g., wells doped with an impurity or structures doped with an impurity.

According to embodiments, the plurality of bit lines BL may each be electrically connected to at least one peripheral circuit from among a plurality of peripheral circuits included in the peripheral circuit structure PCS. The plurality of shielding structures SL may each be floated. Each of the plurality of bit lines BL and each of the plurality of shielding structures SL may be insulated from each other by an interlayer insulation layer 106F. The plurality of shielding structures SL may be covered by an interlayer insulation layer 106G, and the plurality of bit lines BL may penetrate through interlayer insulation layers 106F and 106G in the vertical direction (Z direction). The plurality of bit lines BL may be electrically connected to peripheral circuits included in the peripheral circuit structure PCS through some selected from among a plurality of conductive plugs P1, P2, and P3 and a plurality of wiring layers M1 and M2 included in the peripheral circuit structure PCS. As used herein, components described as being "electrically connected" are configured such that an electrical signal can be transferred from one component to the other (although such electrical signal may be attenuated in strength as it transferred and may be selectively transferred).

The peripheral circuit structure PCS may include a plurality of peripheral circuits 104. The plurality of peripheral circuits 104 may include a first conductive pattern C1 and a second conductive pattern C2 sequentially arranged on the substrate 102. The first conductive pattern C1 and the second conductive pattern C2 may constitute various circuit elements for controlling the functions of a semiconductor device disposed on the peripheral circuit structure PCS. According to embodiments, the peripheral circuit structure PCS may include various active elements, such as transistors, and various passive elements, such as capacitors, resistors, and inductors.

According to embodiments, the plurality of peripheral circuits included in the peripheral circuit structure PCS may include a sub-word line driver block SWD, a sense amplifier block S/A, and/or a control logic. However, the inventive concept is not limited thereto. The plurality of peripheral circuits included in the peripheral circuit structure PCS may include NMOS transistors and PMOS transistors. The plurality of peripheral circuits may be electrically connected to conductive lines (e.g., the plurality of bit lines BL) arranged above the peripheral circuit structure PCS through the plurality of conductive plugs P1, P2, and P3 and the plurality of wiring layers M1 and M2.

In the peripheral circuit structure PCS and the memory cell structure MCS, portions of components from among the plurality of peripheral circuits 104, the plurality of conductive plugs P1, P2, and P3, and the plurality of wiring layers M1 and M2 that need to be mutually insulated may maintain necessary insulation distances therebetween by a plurality of interlayer insulation layers 106A, 106B, 106C, 106D, and 106E. The plurality of interlayer insulation layers 106A, 106B, 106C, 106D, and 106E may each include or be formed of an oxide film, a nitride film, or a combination thereof, but the inventive concept is not limited thereto.

According to some other embodiments, the peripheral circuit structure PCS on the substrate 102 may be omitted. In this case, the peripheral circuit structure PCS may be disposed in another region on the substrate 102 that is spaced apart from the region illustrated in FIGS. 3A and 3C. According to some other embodiments, the peripheral circuit structure PCS may be disposed in a region laterally spaced apart from the memory cell array region MCA with the interface region IA therebetween.

The plurality of bit lines BL and the plurality of shielding structures SL may extend lengthwise in parallel with each other in a first horizontal direction (X direction) on the substrate 102 and may be spaced apart from each other in a second horizontal direction (Y direction) perpendicular to the first horizontal direction (X direction). According to some embodiments, the plurality of bit lines BL may each include or be formed of Ti, TiN, Ta, TaN, Mo, Ru, W, WN, Co, Ni, TiSi, TiSiN, WSi, WSiN, TaSi, TaSiN, RuTiN, CoSi, NiSi, polysilicon, or a combination thereof. However, the inventive concept is not limited thereto. In this specification, each of the bit lines BL may be referred to as a lower conductive line. According to some embodiments, the plurality of shielding structures SL may each include or be formed of W, Al, Cu, or a combination thereof. However, the inventive concept is not limited thereto. According to some embodiments, the plurality of shielding structures SL may each include or be formed of a conductive layer including W, Al, Cu, or a combination thereof and an air gap or a void within the conductive layer. For example, the void may include a gas and/or may be in a vacuum state.

According to embodiments, the semiconductor device 100 may include a plurality of gate composite structures GCS, an isolating insulation pattern 114, a plurality of channel structures 156, a gap-fill insulation structure 176, and a plurality of conductive contact patterns 182, and a plurality of word line contact patterns 186.

According to embodiments, the plurality of gate composite structures GCS may extend lengthwise in the second horizontal direction (Y direction) on the plurality of bit lines BL and the plurality of shielding structures SL and may be space apart from one another in the first horizontal direction (X direction). The plurality of gate composite structures GCS may extend to a portion of the interface region IA through the memory cell array region MCA.

According to some embodiments, the semiconductor device 100 may include a trim pattern 178 disposed in an interface trench IAT extending lengthwise in the first horizontal direction (X direction) in the interface region IA. According to some embodiments, one end of each of the plurality of gate composite structures GCS in the second horizontal direction (Y direction) may contact the trim pattern 178 of the interface region IA. According to some embodiments, the trim pattern 178 may include or be formed of a silicon oxide film, a silicon nitride film, or a combination thereof. It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element, there are no intervening elements present at the point of contact.

According to embodiments, a plurality of isolating insulation patterns 114 may vertically overlap the plurality of gate composite structures GCS, respectively. According to some embodiments, the plurality of isolating insulation patterns 114 may be disposed between the plurality of bit lines BL and the plurality of shielding structures SL and corresponding gate composite structures GCS from among the plurality of gate composite structures GCS. For example, the plurality of gate composite structures GCS may each be spaced apart from a corresponding one of the plurality of bit lines BL with a corresponding isolating insulation pattern 114 from among the plurality of isolating insulation patterns 114 therebetween. According to some embodiments, the plurality of isolating insulation patterns 114 may extend parallel to one another in the second horizontal direction (Y direction), and one end of the isolating insulation pattern 114 in the second horizontal direction (Y direction) may contact the trim pattern 178.

According to embodiments, the plurality of gate composite structures GCS may each include a mold line pattern 120a extending lengthwise in the second horizontal direction (Y direction), a pair of word lines WL contacting both sidewalls of the mold line pattern 120a, and a gate dielectric layer 144. According to some embodiments, the bottom surface of the mold line pattern 120a, the bottom surfaces of the pair of word lines WL, and the bottom surface of the gate dielectric layer 144 may contact the top surface of the corresponding isolating insulation pattern 114. For example, the bottom surface of the mold line pattern 120a, the bottom surfaces of the pair of word lines WL, and the bottom surface of the gate dielectric layer 144 may be arranged on the same plane.

According to some embodiments, the pair of word lines WL may be a first word line WL1 covering/contacting a first sidewall of the mold line pattern 120a and a second word line WL2 covering/contacting a second sidewall opposite to the first sidewall in the first horizontal direction (X direction). The mold line pattern 120a, the first word line WL1, and the second word line WL2 may each contact the top surface of a corresponding isolating insulation pattern 114 from among the plurality of isolating insulation patterns 114 and may be spaced apart from the plurality of bit lines BL and the plurality of shielding structures SL with the corresponding isolating insulation pattern 114 therebetween. The gate dielectric layer 144 may cover the outer surface of a gate structure including the mold line pattern 120a and a pair of word lines WL1 and WL2 on the corresponding isolating insulation pattern 114. In this specification, the first word line WL1 and the second word line WL2 may each be referred to as an upper conductive line.

According to embodiments, the mold line pattern 120a may include a first mold pattern 122 and a second mold pattern 124 sequentially stacked in the vertical direction (Z direction) on a corresponding isolating insulation pattern 114 from among the plurality of isolating insulation patterns 114. According to some embodiments, the first mold pattern 122 and the second mold pattern 124 may each include or be formed of a silicon oxide film, a silicon nitride film, or a combination thereof. For example, the first mold pattern 122 may include or be formed of a silicon oxide film, and the second mold pattern 124 may include or be formed of a silicon nitride film.

According to embodiments, the mold line pattern 120a may have a first sidewall and a second sidewall opposite each other in the first horizontal direction (X direction). The first word line WL1 and the second word line WL2 may cover/contact the first sidewall and the second sidewall of the mold line pattern 120a, respectively, and may extend lengthwise in the second horizontal direction (Y direction). For example, the first word line WL1 may be spaced apart from the second word line WL2 in the first horizontal direction (X direction) with the mold line pattern 120a therebetween. According to some embodiments, the first sidewall and the second sidewall of the mold line pattern 120a may extend linearly/straight in the second horizontal direction (Y direction), e.g., over (by vertically overlapping) the plurality of bit lines BL, and the first word line WL1 and the second word line WL2 may extend linearly/straight in the second horizontal direction (Y direction), e.g., over (by vertically overlapping) the plurality of bit lines BL.

According to embodiments, the first word line WL1 and the second word line WL2 may each include an inner wall WLS1 in contact with the sidewall of the mold line pattern 120a and an outer wall WLS2 in contact with the gate dielectric layer 144. According to some embodiments, the first sidewall and the second sidewall of the mold line pattern 120a may extend linearly/straight in the vertical direction (Z direction), e.g., from the lowermost level to the uppermost level of the mold line pattern 120a. The inner wall WLS1 of each of the first word line WL1 and the second word line WL2 may extend linearly/straight in the vertical direction (Z direction), e.g., from the lowermost levels to the uppermost levels of the first and second word lines WL1 and WL2 respectively, along the profiles of the first sidewall and the second sidewall of the mold line pattern 120a. According to some embodiments, the inner wall WLS1 of each of the first word line WL1 and the second word line WL2 may entirely contact one sidewall of the mold line pattern 120a. According to some embodiments, an upper portion UPW of the outer wall WLS2 may have a rounded/curved shape. According to some embodiments, the distance between the upper portion UPW of the outer wall WLS2 and the sidewall of the mold line pattern 120a facing the corresponding word line WL in the first horizontal direction (X direction) may decrease in a vertical direction receding from a corresponding isolating insulation pattern 114. For example, the upper portion UPW of the outer wall WLS2 may have a curved shape that is convex toward the gate dielectric layer 144. For example, the upper portion UPW of the outer wall WLS2 may have a convex shape protruding toward the gate dielectric layer 144.

According to some embodiments, the inner wall WLS1 and the outer wall WLS2 of each of the first word line WL1 and the second word line WL2 may meet each other at a topmost surface WLT of the first word line WL1 or the second word line WL2. For example, the topmost surface WLT of each of the first word line WL1 and the second word line WL2 may have a line-like shape extending in the second horizontal direction (Y direction). For example, the inner wall WLS1 and the outer wall WLS2 may meet on a line extending in the second horizontal direction (Y direction).

According to some embodiments, the topmost surface WLT of each of the first word line WL1 and the second word line WL2 may be disposed at substantially the same vertical level as the top surface of the mold line pattern 120a. For example, the topmost surface WLT of a word line WL may be located at a first vertical level LV1, and the top surface of the mold line pattern 120a may be located at a level substantially identical to the first vertical level LV1. In this specification, the vertical level refers to the distance in the Z direction or -Z direction, e.g., from a top surface 102U of the substrate 102. Terms such as "same," "equal," "planar," or "coplanar," as used herein encompass identicality or near identicality including variations that may occur, for example, due to manufacturing processes. The term "substantially" may be used herein to emphasize this meaning, unless the context or other statements indicate otherwise.

According to some other embodiments, the topmost surface WLT of each of the first word line WL1 and the second word line WL2 may be disposed at a vertical level lower than that of the top surface of the mold line pattern 120a. In this case, the inner wall WLS1 of each of the first word line WL1 and the second word line WL2 may partially cover the sidewall of the mold line pattern 120a.

According to embodiments, the gate dielectric layer 144 may cover the outer surface of the gate structure including the first word line WL1, the second word line WL2, and the mold line pattern 120a and linearly/straightly extend, e.g., lengthwise, in the second horizontal direction (Y direction), e.g., over (by vertically overlapping) the plurality of bit lines BL. According to some embodiments, the gate dielectric layer 144 may contact the top surface of the mold line pattern 120a, the outer wall WLS2 of the first word line WL1, and the outer wall WLS2 of the second word line WL2 and may contact a portion of the top surface of a corresponding isolating insulation pattern 114 from among the plurality of isolating insulation patterns 114. According to some embodiments, the gate dielectric layer 144 may have a profile corresponding to the outer surface of the gate structure and conformally cover the gate structure. For example, portions of the gate dielectric layer 144 that cover the upper portion UPW of the outer wall WLS2 of the first word line WL1 and the upper portion UPW of the outer wall WLS2 of the second word line WL2 may have a rounded curved shape. According to some embodiments, a vertical cross-section of the gate dielectric layer 144 in the first horizontal direction (X direction) may have a vertically inverted 'U' shape.

According to some embodiments, the plurality of gate composite structures GCS may each have a first width W1, which is a width in the first horizontal direction (X direction). According to some embodiments, the width of each of the plurality of isolating insulation patterns 114 in the first horizontal direction (X direction) may be substantially equal to the first width W1. According to some embodiments, the gate dielectric layer 144 may vertically overlap a corresponding isolating insulation pattern 114 from among the plurality of isolating insulation patterns 114 in the vertical direction (Z direction). For example, the gate structure including the mold line pattern 120a, the first word line WL1, and the second word line WL2 may be surrounded by the gate dielectric layer 144 and the corresponding isolating insulation pattern 114, e.g., in a cross-sectional view.

According to some embodiments, the first word line WL1 and the second word line WL2 may each include or be formed of Ti, TiN, Ta, TaN, Mo, Ru, W, WN, TiSiN, WSiN, polysilicon, or a combination thereof.

According to some embodiments, the gate dielectric layer 144 may include or be formed of a high-k film having a higher dielectric constant than a silicon oxide film. According to embodiments, the gate dielectric layer 144 may include or be formed of at least one material selected from the group consisting of among hafnium oxide (HfO), hafnium silicate (HfSiO), hafnium oxynitride (HfON), hafnium silicon oxynitride (HfSiON), lanthanum oxide (LaO), lanthanum aluminum oxide (LaAlO), zirconium oxide (ZrO), zirconium silicate (ZrSiO), zirconium oxynitride (ZrON), zirconium silicon oxynitride (ZrSiON), tantalum oxide (TaO), titanium oxide (TiO), barium strontium titanium oxide (BaSrTiO), barium titanium oxide (BaTiO), lead zirconate titanate (PZT), strontium bismuth tantalate (STB), bismuth iron oxide (BFO), strontium titanium oxide (SrTiO), yttrium oxide (YO), aluminum oxide (AlO), and lead scandium tantalum oxide (PbScTaO).

According to some embodiments, the plurality of isolating insulation patterns 114 may include or be formed of a silicon oxide film, a silicon nitride film, the high-k film having a higher dielectric constant than the silicon oxide film, or a combination thereof. According to some embodiments, the plurality of isolating insulation patterns 114 may include or be formed of the same material as the gate dielectric layer 144. According to some other embodiments, the plurality of isolating insulation patterns 114 may include or be formed of a material different from that constituting the gate dielectric layer 144.

According to embodiments, in the memory cell array region MCA, the plurality of channel structures 156 may be arranged in the second horizontal direction (Y direction) between the plurality of gate composite structures GCS. According to embodiments, the plurality of channel structures 156 may each contact one bit line BL selected from the plurality of bit lines BL and face two adjacent word lines WL in the first horizontal direction (X direction). For example, a gate dielectric layer 144 may be provided between two adjacent channel structures 156 and the two adjacent word lines WL. For example, a portion of the gate dielectric layer 144 may be interposed between a channel structure 156 and a word line WL, and another portion of the gate dielectric layer 144 may be interposed between another channel structure 156 and another word line WL.

For example, a first group of channel structures 156 may be arranged between a first gate composite structure GCS and a second gate composite structure GCS that are adjacent to each other. For example, the first group of channel structures 156 may be arranged in a row in the second horizontal direction (Y direction). Each channel structure 156 of the first group of channel structures may contact facing sides of the first gate composite structure GCS and the second gate composite structure GCS (such facing sides facing each other in the first horizontal direction (X direction)). According to some embodiments, a first isolating insulation pattern 114 may be disposed between the first gate composite structure GCS and the plurality of bit lines BL, and a second isolating insulation pattern 114 may be disposed between the second gate composite structure GCS and the plurality of bit lines BL. For example, one sidewall 114s of the first isolating insulation pattern 114 and one sidewall 114s of the second isolating insulation pattern 114 may face each other in the first horizontal direction (X direction). According to some embodiments, each channel structure 156 of the first group of channel structures 156 may contact these opposing sidewalls 114s (i.e., the sidewall 114s of the first isolating insulation pattern 114 and the sidewall 114s of the second isolating insulation pattern 114 facing each other). According to some embodiments, each channel structure 156 of the first group of channel structures 156 may have a side that contacts the gate dielectric layer 144 of the first gate composite structure GCS on a side of the gate dielectric layer 144 of the first gate composite structure GCS that faces the channel structure 156 in the first horizontal direction (X direction), such a side facing the second word line WL2 of the first gate composite structure GCS and having the gate dielectric layer 144 disposed therebetween. According to some embodiments, each of the first group of channel structures 156 may have another side that contact the gate dielectric layer 144 of the second gate composite structure GCS on a side of the gate dielectric layer 144 of the second gate composite structure GCS that faces the channel structure 156 in the first horizontal direction (X direction), such a side facing the first word line WL1 of the second gate composite structure GCS and having the gate dielectric layer 144 disposed therebetween. For example, the first word line WL1 of each gate composite structure GCS may be disposed on a first sidewall of the mold line pattern 120a (e.g., a left sidewall in FIG. 3A) and the second word line WL2 of each gate composite structure GCS may be disposed on a second sidewall of the mold line pattern 120a (e.g., a right sidewall in FIG. 3A) opposite the first sidewall of the mold line pattern 120a as shown in FIG. 3A.

According to some embodiments, the plurality of word lines WL may be respectively spaced apart from the plurality of bit lines BL in the vertical direction (Z direction) with the plurality of isolating insulation patterns 114 therebetween. The plurality of channel structures 156 may each contact the top surface of one selected from among the plurality of bit lines BL and contact the sidewalls 114s of the isolating insulation patterns 114. According to some embodiments, the plurality of channel structures 156 may not include portions between the plurality of word lines WL and the plurality of bit lines BL. For example, the channel structures 156 may be spaced apart from each other in the first horizontal direction (X direction) and in the second horizontal direction (Y direction). According to some embodiments, the plurality of channel structures 156 may each include a bottom portion 156a in contact with a corresponding bit line BL from among the plurality of bit lines BL and two facing portions 156b facing the word lines WL respectively.

According to some embodiments, the bottom portion 156a may contact the top surface of the bit line BL and the top surface of the interlayer insulation layer 106G. A first facing portion 156b of the two facing portions 156b may extend in the vertical direction (Z direction) from one end of the bottom portion 156a in the first horizontal direction (X direction) and cover/contact one sidewall of the first gate composite structure GCS. A second facing portion 156b of the two facing portions 156b may extend in the vertical direction (Z direction) from the other end of the bottom portion 156a in the first horizontal direction (X direction) and cover/contact one sidewall of the second gate composite structure GCS from among the plurality of gate composite structures GCS. According to some embodiments, the bottom portion 156a may extend between the first facing portion 156b and the second facing portion 156b and may overlap the gap-fill insulation structure 176 in the vertical direction (Z direction). According to some embodiments, the first facing portion 156b and the second facing portion 156b may be spaced apart from each other in the first horizontal direction (X direction) with the gap-fill insulation structure 176 therebetween. According to some embodiments, a vertical cross-section of each of the plurality of channel structures 156 in the first horizontal direction (X direction) may have a 'U' shape.

According to some embodiments, the facing portions 156b of each of the plurality of channel structures 156 may partially cover the outer surface of a corresponding gate composite structure GCS from among the plurality of gate composite structures GCS. For example, a facing portion 156b may contact the gate dielectric layer 144 and at least partially cover (e.g., horizontally overlap) the outer wall WLS2 of the word line WL.

According to some embodiments, the facing portion 156b may include an extended portion UPC having a curved shape, such that the upper portion of the facing portion 156b has a profile corresponding to the upper portion UPW of the outer wall WLS2 of the word line WL. For example, the extended portion UPC is a portion of the facing portion 156b and may face the upper portion UPW of the outer wall WLS2 of the word line WL with the gate dielectric layer 144 therebetween. For example, the extended portion UPC may overlap the upper portion UPW of the outer wall WLS2 of the word line WL in the first horizontal direction (X direction). According to some embodiments, the distance between the extended portion UPC and the mold line pattern 120a in the first horizontal direction (X direction) may decrease as the distance from the bottom portion 156a to the extended portion UPC in the vertical direction (Z direction) increases. For example, the distance between the extended portion UPC and the mold line pattern 120a in the first horizontal direction (X direction) may decrease in a direction receding from the bottom portion 156a.

According to some embodiments, the plurality of channel structures 156 may each include an oxide semiconductor layer containing IGZO (InGaZnO), Sn-IGZO, IWO (InWO), IZO (InZnO), ZTO (ZnSnO), ZnO, YZO (yttrium-doped zinc oxide), IGSO (InGaSiO), InO, SnO, TiO, ZnON, MgZnO, ZrInZnO, Hf InZnO, SnInZnO, SiInZnO, GaZnSnO, ZrZnSnO, or a combination thereof. For example, the plurality of channel structures 156 may include IGZO. According to some other embodiments, the plurality of channel structures 156 may each include Si, Ge, SiGe, a Group III-V compound semiconductor, or a combination thereof. The group III-V compound semiconductor may include GaAs or InSb, but is not limited thereto.

According to embodiments, the gap-fill insulation structure 176 may cover (e.g., vertically overlap) the plurality of channel structures 156 and the plurality of gate composite structures GCS on the plurality of bit lines BL and the plurality of shielding structures SL. According to embodiments, the gap-fill insulation structure 176 may fill spaces between the plurality of gate composite structures GCS. According to some embodiments, the gap-fill insulation structure 176 may include a portion in contact with the plurality of channel structures 156 and a portion in contact with a plurality of gate dielectric layers 144. According to some embodiments, the gap-fill insulation structure 176 may include a portion in contact with sidewalls 114s of the plurality of isolating insulation patterns 114 and a portion in contact with the interlayer insulation layer 106G.

According to some embodiments, the gap-fill insulation structure 176 may include or be formed of a first gap-fill layer 172 covering the plurality of channel structures 156 and a second gap-fill layer 174 on the first gap-fill layer 172. According to some embodiments, the first gap-fill layer 172 and the second gap-fill layer 174 may each include or be formed of a silicon oxide film, a silicon nitride film, or a combination thereof. However, the inventive concept is not limited thereto. According to some embodiments, the first gap-fill layer 172 and the second gap-fill layer 174 may include or be formed of materials different from each other. For example, the first gap-fill layer 172 may include or be formed of a silicon oxide film, and the second gap-fill layer 174 may include or be formed of a silicon nitride film. Although FIGS. 3A to 4B illustrate that the gap-fill insulation structure 176 includes two gap-fill layers 172 and 174, the inventive concept is not limited thereto. For example, the gap-fill insulation structure 176 may include or be formed of a single gap-fill layer or may include or be formed of three or more gap-fill layers.

According to some embodiments, the facing portion 156b of each of the plurality of channel structures 156 may have a first surface 156S1 in contact with the gate dielectric layer 144 and a second surface 156S2 in contact with the first gap-fill layer 172. According to some embodiments, the first surface 156S1 may face the word line WL with the gate dielectric layer 144 therebetween. According to some embodiments, the upper portion of the first surface 156S1 may face the upper portion UPW of the outer wall WLS2 of the word line WL with the gate dielectric layer 144 therebetween. According to some embodiments, the upper portion of the second surface 156S2 may have a rounded convexly-curved shape.

According to embodiments, in the memory cell array region MCA, the plurality of conductive contact patterns 182 may be arranged on the facing portions 156b of the plurality of channel structures 156. The plurality of conductive contact patterns 182 may each be connected to one facing portion 156b selected from among the facing portions 156b of the plurality of channel structures 156.

As illustrated in FIGS. 3A and 4A, the plurality of conductive contact patterns 182 may each include a lower contact portion 182L, which fills a first contact hole CTH1 penetrating through the gap-fill insulation structure 176 and contact a channel structure 156, and an upper pad portion 182U, which is disposed on the lower contact portion 182L and integrally connected to the lower contact portion 182L, e.g., as one body. For example, the upper pad portion 182U may be disposed on the top surface of the gap-fill insulation structure 176, and sidewalls of the upper pad portion 182U may be surrounded by a first interlayer insulation layer 184. According to some embodiments, upper pad portions 182U of the plurality of conductive contact patterns 182 may be respectively spaced apart from the plurality of gate composite structures GCS in the vertical direction (Z direction) with the gap-fill insulation structure 176 therebetween. According to some embodiments, lower contact portions 182L of the plurality of conductive contact patterns 182 may be insulated from one another by the gap-fill insulation structure 176, and the upper pad portions 182U of the plurality of conductive contact patterns 182 may be insulated from one another by the first interlayer insulation layer 184.

According to some embodiments, the lower contact portion 182L of each of the plurality of conductive contact patterns 182 may be in contact with a top surface 156U of a corresponding facing portion 156b from among the facing portions 156b of the plurality of channel structures 156. According to some embodiments, the top surface 156U of the facing portion 156b may contact a bottom surface 182B of the lower contact portion 182L at the first vertical level LV1.

According to some embodiments, the top surface 156U of the facing portion 156b may be substantially parallel to the top surface 102U of the substrate 102. The plurality of channel structures 156 of the semiconductor device 100 according to embodiments include the facing portions 156b each having a curved extended portion UPC, wherein the top surface 156U of the facing portion 156b may be substantially parallel to the top surface 102U of the substrate 102. According to some embodiments, the width of the top surface 156U of the facing portion 156b in the first horizontal direction (X direction) may be greater than the thickness of the channel structure 156, e.g., the thickness of the bottom portion 156a in the vertical direction (Z direction). Therefore, the contacting areas between the plurality of conductive contact patterns 182 and the facing portions 156b of the plurality of channel structures 156 increase or are secured, and thus the electrical reliability of transistors constituting memory cells of the semiconductor device 100 may be improved. In this specification, the top surface 156U of the facing portion 156b may be referred to as the topmost surface of the channel structure 156.

According to some embodiments, the bottommost surface of the lower contact portion 182L of each of the plurality of conductive contact patterns 182 may be located at a vertical level substantially identical to or lower than that of the topmost surface WLT of the plurality of word lines WL. Therefore, the electrical characteristics of the semiconductor device may be improved by reducing power loss while securing the length of a channel.

As illustrated in FIG. 2, the plurality of conductive contact patterns 182 may be regularly arranged in the first horizontal direction (X direction) and the second horizontal direction (Y direction) at regular intervals. Although FIG. 1 shows an example in which the plurality of conductive contact patterns 182 are arranged in a matrix-like structure on a plane (e.g., the XY plane) on the substrate 102, the inventive concept is not limited thereto. For example, the plurality of conductive contact patterns 182 may be arranged in a honeycomblike structure on a plane (e.g., the XY plane) on the substrate 102. The plurality of conductive contact patterns 182 may be insulated from one another by the first interlayer insulation layer 184.

Although FIGS. 3A and 4A illustrate that the lower contact portion 182L of each of the plurality of conductive contact patterns 182 does not contact the gate dielectric layer 144 or contacts the gate dielectric layer 144 only at a portion of the boundary of the top surface 156U of the facing portion 156b, the inventive concept is not limited thereto. For example, the lower contact portion 182L may include a portion in contact with the gate dielectric layer 144 and facing the word line WL with the gate dielectric layer 144 therebetween.

According to some embodiments, a plurality of storage nodes 192 may be arranged on the plurality of conductive contact patterns 182 respectively. The plurality of storage nodes 192 may include or may be metal-insulator-metal (MIM) capacitors. For example, the plurality of storage nodes 192 may include or may be MIM capacitors each including a lower electrode, a capacitor dielectric layer, and an upper electrode. The lower electrode may be disposed on a corresponding one of the plurality of conductive contact patterns 182, and the capacitor dielectric layer and the upper electrode may be disposed to conformally cover the lower electrode. According to other embodiments, the plurality of storage nodes 192 may include or may be memory elements such as variable resistance memory elements, phase-change memory elements, and magnetic memory elements.

According to embodiments, in the interface region IA, the plurality of word line contact patterns 186 may be arranged on the plurality of word lines WL, respectively. According to embodiments, each word line contact pattern 186 of the plurality of word line contact patterns 186 may be electrically connected to or contact one selected from among the plurality of word lines WL.

As illustrated in FIGS. 3B and 4B, the plurality of word line contact patterns 186 may each include a lower contact portion 186L, which fills a second contact hole CTH2 penetrating through the gap-fill insulation structure 176 and the gate dielectric layer 144 and contacts the word line WL, and an upper pad portion 186U, which is disposed on the lower contact portion 186L and integrally connected to the lower contact portion 186L, e.g., as one body. For example, the upper pad portion 186U may be disposed on the top surface of the gap-fill insulation structure 176, and sidewalls of the upper pad portion 186U may be surrounded by a second interlayer insulation layer 185. According to some embodiments, upper pad portions 186U of the plurality of word line contact patterns 186 may be respectively spaced apart from the plurality of gate composite structures GCS in the vertical direction (Z direction) with the gap-fill insulation structure 176 therebetween. According to some embodiments, lower contact portions 186L of the plurality of word line contact patterns 186 may be insulated from one another by the gap-fill insulation structure 176, and the upper pad portions 186U of the plurality of word line contact patterns 186 may be insulated from one another by the second interlayer insulation layer 185.

According to some embodiments, the plurality of word line contact patterns 186 and the plurality of conductive contact patterns 182 may each include or be formed of Ti, TiN, Ta, TaN, Mo, Ru, W, WN, TiSiN, WSiN, Ni, or a combination thereof. For example, the plurality of word line contact patterns 186 and the plurality of conductive contact patterns 182 may each have a stacked structure of a conductive barrier film containing TiN and a conductive film containing W. According to some embodiments, the first interlayer insulation layer 184 and the second interlayer insulation layer 185 may each include or be formed of an oxide film, a nitride film, or a combination thereof, but the inventive concept is not limited thereto.

Although FIGS. 2 and 3B illustrate that the plurality of word line contact patterns 186 are arranged in a row in the first horizontal direction (X direction), the inventive concept is not limited thereto. For example, the plurality of word line contact patterns 186 may be arranged in a zig-zag shape in the first horizontal direction (X direction). Although FIG. 2 illustrates that the planar shape of each of the plurality of conductive contact patterns 182 is a circular shape and the planar shape of each of the plurality of word line contact patterns 186 is a rectangular shape, the inventive concept is not limited thereto.

According to some embodiments, a plurality of upper wiring patterns 194 may be arranged on the plurality of word line contact patterns 186, respectively, and the plurality of word line contact patterns 186 may each contact and be electrically connected to one selected from among the upper wiring patterns 194. The plurality of upper wiring patterns 194 may be insulated from one another and may be configured to apply voltages to different word lines WL, respectively.

The plurality of word lines WL of the semiconductor device 100 according to embodiments may each longitudinally extend linearly/straight in the second horizontal direction (Y direction), e.g., over (by vertically overlapping) the plurality of bit lines BL. The plurality of gate dielectric layers 144 may each cover a pair of word lines WL1 and WL2 adjacent to each other from among the plurality of word lines WL and longitudinally extend linearly/straight in the second horizontal direction (Y direction). For example, a word line structure including the pair of word lines WL1 and WL2 and one gate dielectric layer 144 longitudinally extends linearly/straight, e.g., over the plurality of bit lines BL, and thus a semiconductor device including the word line structure may exhibit improved structural stability and improved electrical reliability as compared to a semiconductor device according to a comparative example in which the word line structure extends in a zig-zag shape or forms a concavo-convex structure in a plan view. Also, a contact hole accommodating the lower contact portion 182L facilitates formation of the gap-fill insulation structure 176 with low process difficulty through dry etching without causing excessive damage to the gate dielectric layer 144. For example, wet etching, which causes excessive damage to the gate dielectric layer 144, may be omitted in the process of forming the contact hole.

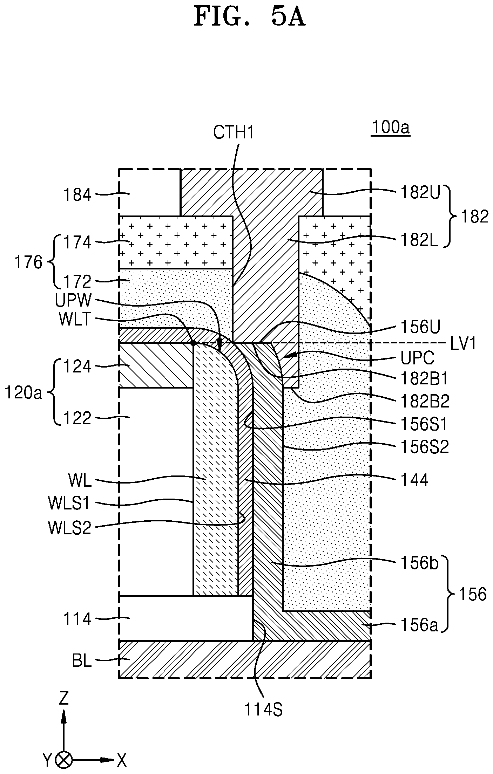

FIG. 5A is a diagram illustrating a semiconductor device 100a according to other embodiments and is a cross-sectional view of a portion corresponding to the portion indicated as "EXB1" in FIG. 3A. In FIG. 5A, the same reference numerals as those in FIGS. 1 to 4B denote the same members, and repeated descriptions thereof will be omitted below.

Referring to FIG. 5A, the semiconductor device 100a has substantially the same configuration as the semiconductor device 100 described above with reference to FIGS. 1 to 4B. However, in the semiconductor device 100a, the lower contact portion 182L of a conductive contact pattern 182 partially covers the second surface 156S2 of the facing portion 156b of the channel structure 156. For example, the semiconductor device 100a may have the same configuration as the semiconductor device 100 described above with reference to FIGS. 1 to 4B except for the configuration described below.

According to some embodiments, the lower contact portion 182L may have a first bottom surface 182B1 in contact with the top surface 156U of the facing portion 156b and a second bottom surface 182B2 in contact with the first gap-fill layer 172. The second bottom surface 182B2 of the lower contact portion 182L may be the bottommost surface closest to the substrate 102 in the lower contact portion 182L. For example, the second bottom surface 182B2 of the lower contact portion 182L may be located at a vertical level lower than that of the first bottom surface 182B1. According to some embodiments, the second bottom surface 182B2 of the lower contact portion 182L may be the bottommost surface of the lower contact portion 182L and may be located to be closer to the substrate 102 than a place where the topmost surface WLT of the word line WL is.

For example, the second bottom surface 182B2 of the lower contact portion 182L may be located closer to the substrate 102 than a place where the first bottom surface 182B 1 is.

According to some embodiments, the lower contact portion 182L may cover the extended portion UPC of the facing portion 156b. For example, a first portion of the second surface 156S2 of the facing portion 156b constituting the surface of the extended portion UPC may contact the lower contact portion 182L. The facing portion 156b of the semiconductor device 100a according to embodiments includes a curved extended portion UPC. Therefore, the first portion of the second surface 156S2 of the facing portion 156b is configured as a curved surface, and thus the contact area between the lower contact portion 182L and the facing portions 156b may be increased, e.g., compared to the previous embodiments. Even when the horizontal width of a contact hole for forming the lower contact portion 182L has an extremely small critical dimension (CD), a sufficient contact area may be secured in this way.

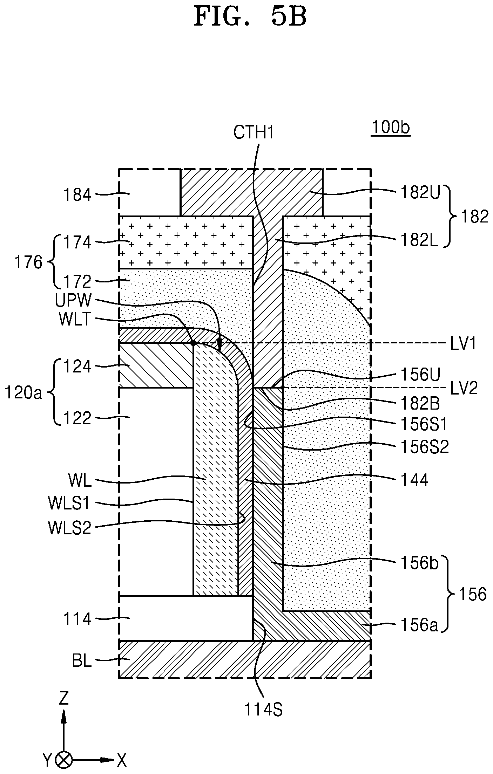

FIG. 5B is a diagram illustrating a semiconductor device 100b according to other embodiments and is a cross-sectional view of a portion corresponding to the portion indicated as "EXB1" in FIG. 3A. In FIG. 5B, the same reference numerals as those in FIGS. 1 to 4B denote the same members, and repeated descriptions thereof will be omitted below.

Referring to FIG. 5B, the semiconductor device 100b has substantially the same configuration as the semiconductor device 100 described above with reference to FIGS. 1 to 4B. However, in the semiconductor device 100b, the top surface 156U of the facing portion 156b of the channel structure 156 is disposed at a vertical level lower than that of the topmost surface WLT of the word line WL. For example, the semiconductor device 100b may have the same configuration as the semiconductor device 100 described above with reference to FIGS. 1 to 4B except for the configuration described below.

According to embodiments, the top surface 156U of the facing portion 156b of the channel structure 156 may be disposed at a second vertical level LV2 that is lower than the first vertical level LV1. According to some embodiments, the facing portion 156b may not include a portion that faces or horizontally overlaps the upper portion UPW of the outer wall WLS2 of the word line WL. For example, the facing portion 156b of the semiconductor device 100b may not include the extended portion UPC of the semiconductor device 100 described above with reference to FIGS. 1 to 4B. As shown in FIG. 5B, the lower contact portion 182L of the conductive contact pattern 182 may not vertically overlap the gate dielectric layer 144 and the word line WL. According to some embodiments, the conductive contact pattern 182 may not vertically overlap the gate dielectric layer 144 and the word line WL. According to some embodiments, the facing portion 156b may cover a portion of the outer surface of the gate dielectric layer 144 and extend linearly/straight in the vertical direction (Z direction), e.g., from the lowermost level to the uppermost level of the facing portion 156b.

Although FIG. 5B illustrates that the lower contact portion 182L of the conductive contact pattern 182 is in contact with the top surface 156U of the facing portion 156b of the channel structure 156 and the lower contact portion 182L does not vertically overlap the gate dielectric layer 144 and the word line WL, the inventive concept is not limited thereto. For example, the lower contact portion 182L may partially cover the word line WL and the gate dielectric layer 144 and may include a portion that vertically overlaps the word line WL and the gate dielectric layer 144.

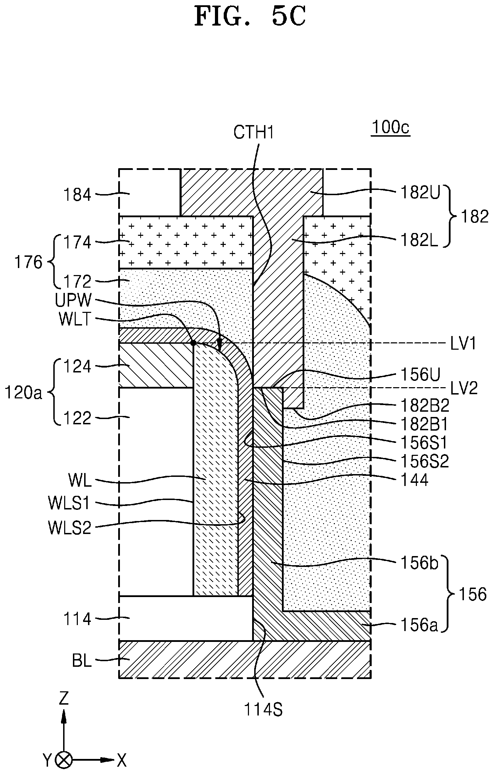

FIG. 5C is a diagram illustrating a semiconductor device 100c according to other embodiments and is a cross-sectional view of a portion corresponding to the portion indicated as "EXB1" in FIG. 3A. In FIG. 5C, the same reference numerals as those in FIGS. 1 to 5B denote the same members, and repeated descriptions thereof will be omitted below. For example, the semiconductor device 100c may have the same configuration as the semiconductor device 100 described above with reference to FIGS. 1 to 4B except for the configuration described below.

Referring to FIG. 5C, the top surface 156U of the facing portion 156b of the channel structure 156 may be disposed at the second vertical level LV2 that is lower than the first vertical level LV1. According to some embodiments, the facing portion 156b may not include a portion that faces or horizontally overlaps the upper portion UPW of the outer wall WLS2 of the word line WL. For example, the facing portion 156b of the semiconductor device 100b may not include the extended portion UPC of the semiconductor device 100 described above with reference to FIGS. 1 to 4B. As shown in FIG. 5C, the lower contact portion 182L of the conductive contact pattern 182 may not vertically overlap the gate dielectric layer 144 and the word line WL. According to some embodiments, the conductive contact pattern 182 may not vertically overlap the gate dielectric layer 144 and the word line WL. According to some embodiments, the facing portion 156b may cover a portion of the outer surface of the gate dielectric layer 144 and extend linearly/straight in the vertical direction (Z direction), e.g., from the lowermost level to the uppermost level of the facing portion 156b.

According to some embodiments, the lower contact portion 182L may have the first bottom surface 182B1 in contact with the top surface 156U of the facing portion 156b and the second bottom surface 182B2 in contact with the first gap-fill layer 172. For example, the first bottom surface 182B1 may be located at the second vertical level LV2, and the second bottom surface 182B2 may be located at a vertical level lower than the second vertical level LV2. The second bottom surface 182B2 of the lower contact portion 182L may be the bottommost surface closest to the substrate 102 in the lower contact portion 182L. For example, the second bottom surface 182B2 of the lower contact portion 182L may be located closer to the substrate 102 than a place where the first bottom surface 182B1 is.

According to some embodiments, the lower contact portion 182L may cover the upper portion of the facing portion 156b. For example, the upper portion of the second surface 156S2 of the facing portion 156b of the channel structure 156 may contact the lower contact portion 182L. According to some embodiments, the first bottom surface 182B1 of the lower contact portion 182L may vertically overlap the facing portion 156b, and the second bottom surface 182B2 may be spaced apart from the bottom portion 156a in the vertical direction (Z direction) with the first gap-fill layer 172 therebetween.

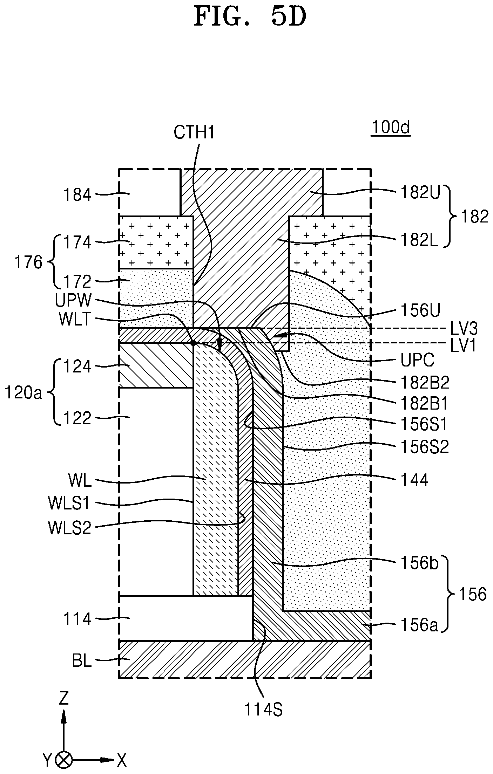

FIG. 5D is a diagram illustrating a semiconductor device 100d according to other embodiments and is a cross-sectional view of a portion corresponding to the portion indicated as "EXB1" in FIG. 3A. In FIG. 5D, the same reference numerals as those in FIGS. 1 to 5C denote the same members, and repeated descriptions thereof will be omitted below.

Referring to FIG. 5D, the semiconductor device 100d has substantially the same configuration as the semiconductor device 100 described above with reference to FIGS. 1 to 4B. However, in the semiconductor device 100d, the top surface 156U of the facing portion 156b of the channel structure 156 is disposed at a vertical level higher than that of the topmost surface WLT of the word line WL. For example, the semiconductor device 100d may have the same configuration as the semiconductor device 100 described above with reference to FIGS. 1 to 4B except for the configuration described below.

According to some embodiments, the top surface 156U of the facing portion 156b of the channel structure 156 may be located at a third vertical level LV3 that is higher than the first vertical level LV1. According to some embodiments, the extended portion UPC of the facing portion 156b of the channel structure 156 may vertically overlap an adjacent word line WL among the plurality of word lines WL at least partially. According to some embodiments, the width of the top surface 156U of the facing portion 156b in the first horizontal direction (X direction) may be greater than the thickness of the channel structure 156, e.g., the thickness of the bottom portion 156a in the vertical direction (Z direction). According to some embodiments, the top surface 156U of the facing portion 156b and the top surface of the gate dielectric layer 144 may be located at substantially the same vertical level. Therefore, the area of the top surface 156U of the facing portion 156b may increase (e.g., comparing with the previous embodiments), and the contact area between the conductive contact pattern 182 and the facing portion 156b may increase (e.g., comparing with the previous embodiments).

According to some embodiments, the lower contact portion 182L may have the first bottom surface 182B1 in contact with the top surface 156U of the facing portion 156b and the second bottom surface 182B2 in contact with the first gap-fill layer 172. The second bottom surface 182B2 of the lower contact portion 182L may be the bottommost surface closest to the substrate 102 in the lower contact portion 182L. For example, the second bottom surface 182B2 of the lower contact portion 182L may be located closer to the substrate 102 than a place where the first bottom surface 182B 1 is.

According to some embodiments, the lower contact portion 182L may cover the extended portion UPC of the facing portion 156b at least partially. For example, the first portion of the second surface 156S2 of the facing portion 156b constituting the surface of the extended portion UPC may contact the lower contact portion 182L.

Although FIG. 5D illustrates that the lower contact portion 182L does not vertically overlap the mold line pattern 120a, the inventive concept is not limited thereto. Also, although FIG. 5D illustrates that the lower contact portion 182L partially covers/contacts the expanded portion UPC of the facing portion 156b of the channel structure 156 and contacts the first gap-fill layer 172 at the second bottom surface 182B2, the inventive concept is not limited thereto. For example, the lower contact portion 182L may entirely cover/contact the extended portion UPC, and a sidewall of the lower contact portion 182L may be aligned with the second surface 156S2 of the facing portion 156b in the vertical direction. For example, the sidewall of the lower contact portion 182L may be on the same vertical plane as the second surface 156S2 of the facing portion 156b.

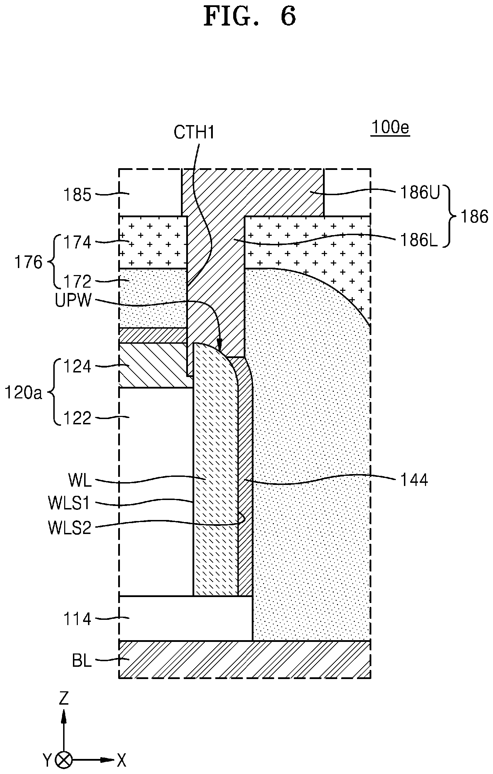

FIG. 6 is a diagram illustrating a semiconductor device 100e according to other embodiments and is a cross-sectional view of a portion corresponding to the portion indicated as "EXB2" in FIG. 3B. In FIG. 6, the same reference numerals as those in FIGS. 1 to 4B denote the same members, and repeated descriptions thereof will be omitted below.

Referring to FIG. 6, the semiconductor device 100e has substantially the same configuration as the semiconductor device 100 described above with reference to FIGS. 1 to 4B. However, in the semiconductor device 100e, the lower contact portion 186L of a word line contact pattern 186 may partially penetrate the mold line pattern 120a. For example, the semiconductor device 100e may have the same configuration as the semiconductor device 100 described above with reference to FIGS. 1 to 4B except for the configuration described below.

According to some embodiments, the lower contact portion 186L of the word line contact pattern 186 may partially overlap the mold line pattern 120a in the vertical direction. According to some embodiments, the lower contact portion 186L may partially penetrate the mold line pattern 120a in the vertical direction and partially contact the inner wall WLS1 of the word line WL. According to some embodiments, the bottom surface of a portion of the lower contact portion 186L vertically overlapping the mold line pattern 120a may be disposed at a vertical level lower than that of the bottom surface of a portion of the lower contact portion 186L vertically overlapping the word line WL.

Although FIG. 6 illustrates that the width of the lower contact portion 186L of the word line contact pattern 186 in the first horizontal direction (X direction) is greater than the width of the word line WL in the first horizontal direction (X direction), the inventive concept is not limited thereto. For example, the width of the lower contact portion 186L of the word line contact pattern 186 in the first horizontal direction (X direction) may be equal to or smaller than the width of the word line WL in the first horizontal direction (X direction).

Hereinafter, a method of manufacturing a semiconductor device according to embodiments will be described with reference to specific examples.

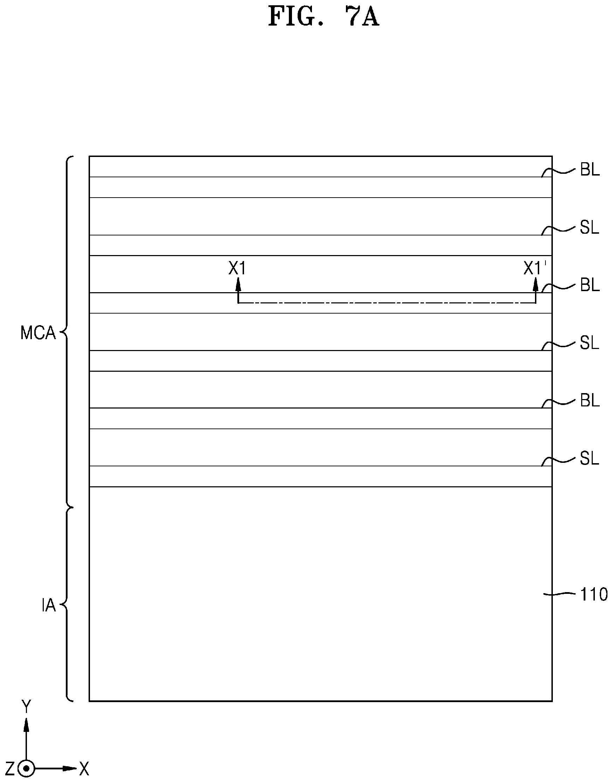

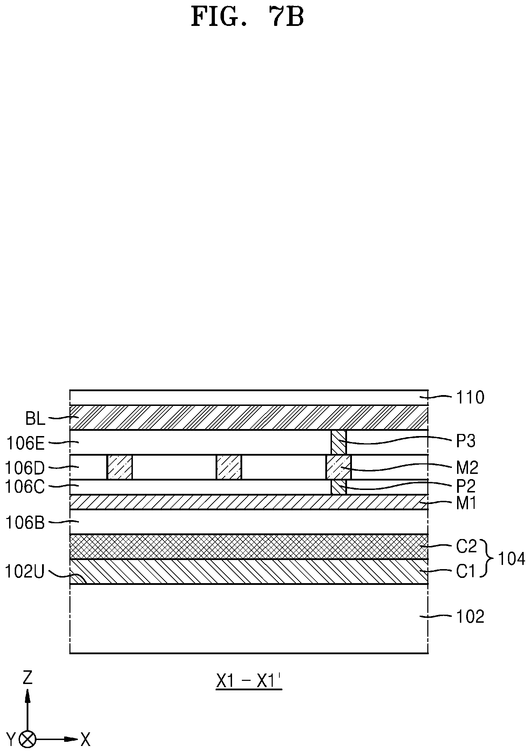

FIGS. 7A to 16B are diagrams illustrating a method of manufacturing the semiconductor device 100 according to embodiments, according to a process sequence. In detail, FIGS. 7A, 8A, 12A, 14A, 15A, and 16A are plan layout diagrams showing some configurations according to the process sequence to describe the method of manufacturing the semiconductor device 100, and FIG. 7B, FIGS. 8B, 9, 10, 11, 12B, 13, 14B, 15B, and 16B are cross-sectional views of a portion corresponding to a line X1-X1' of FIG. 2, according to the process sequence. In FIGS. 7A to 16B, the same reference numerals as those in FIGS. 1 to 4B denote the same members, and detailed descriptions thereof will be omitted below.

Referring to FIGS. 7A and 7B, a plurality of peripheral circuits including the plurality of peripheral circuits 104, the plurality of conductive plugs P1, P2, and P3, and the plurality of wiring layers M1 and M2 may be formed on the substrate 102, thereby forming the peripheral circuit structure PCS on the substrate 102. Thereafter, the interlayer insulation layer 106F (refer to FIG. 3C) and the plurality of shielding structures SL penetrating through the interlayer insulation layer 106F may be formed on the peripheral circuit structure PCS, the interlayer insulation layer 106G covering the interlayer insulation layer 106F and the plurality of shielding structures SL may be formed, and the plurality of bit lines BL penetrating through the interlayer insulation layers 106F and 106G (refer to FIG. 3C) may be formed.

Thereafter, an isolating insulation layer 110 may be formed on the plurality of bit lines BL and the interlayer insulation layer 106G. The isolating insulation layer 110 may contact the top surfaces of the plurality of bit lines BL and the top surface of the interlayer insulation layer 106G.

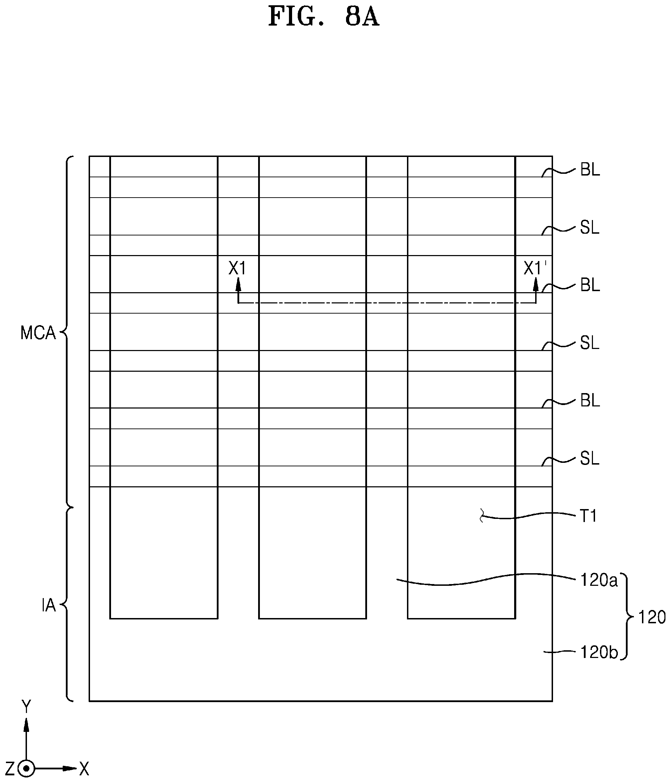

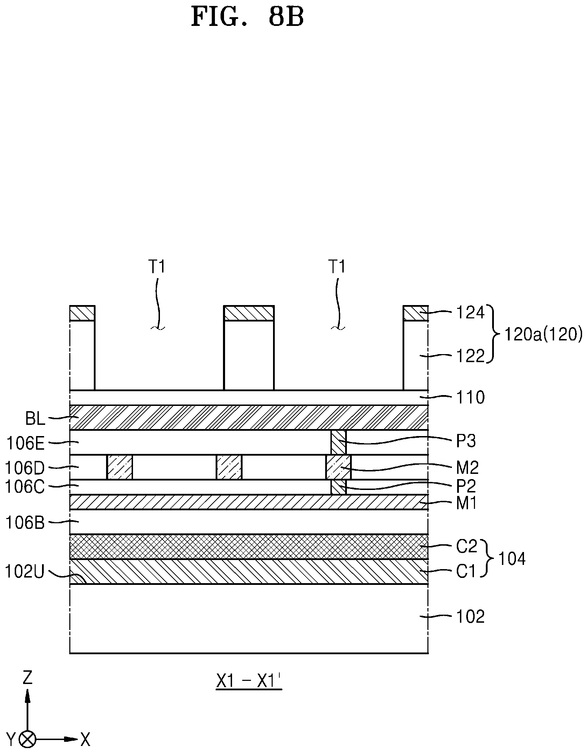

Referring to FIGS. 8A and 8B, in a result structure of FIGS. 7A and 7B, a first mold film and a second mold film may be sequentially formed on the isolating insulation layer 110, a first mask pattern (not shown) exposing a portion of the second mold film may be formed on the second mold film, and portions of the first mold film and the second mold film may be removed by using the first mask pattern (not shown) as an etching mask, thereby forming a mold structure 120 having a plurality of first trenches T1 exposing the isolating insulation layer 110. For example, the plurality of first trenches T1 may extend lengthwise in the second horizontal direction (Y direction). The mold structure 120 may include the first mold pattern 122 and the second mold pattern 124 sequentially stacked on the isolating insulation layer 110.

According to some embodiments, the mold structure 120 may include a plurality of mold line patterns 120a extending lengthwise in the second horizontal direction (Y direction) and a mold merge pattern 120b that meets the plurality of mold line patterns 120a. For example, the plurality of mold line patterns 120a may be arranged in portions of the memory cell array region MCA and the interface region IA and may be spaced apart from one another in the first horizontal direction (X direction).

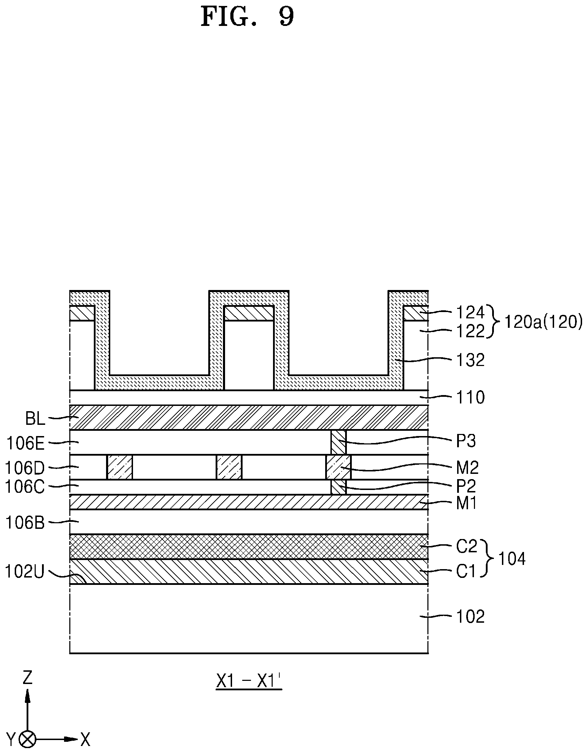

Referring to FIG. 9, a conductive layer 132 conformally covering a result structure of FIGS. 8A and 8B may be formed. According to some embodiments, the conductive layer 132 may cover the top surface of the mold structure 120 and the bottom surfaces and the inner walls of the plurality of first trenches T1. For example, the conductive layer 132 may be in contact with the top surface of the mold structure 120, sidewalls of the plurality of mold line patterns 120a, and a portion of the top surface of the isolating insulation layer 110 that does not vertically overlap the mold structure 120.

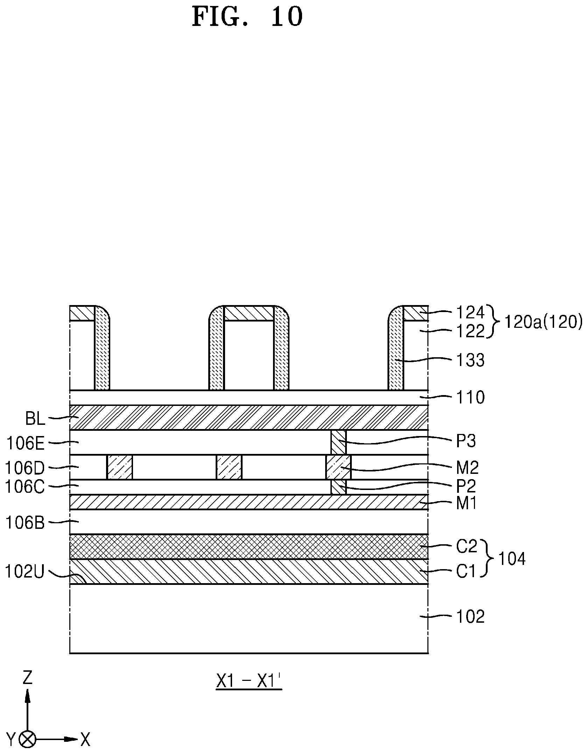

Referring to FIG. 10, in a result structure of FIG. 9, a plurality of conductive patterns 133 may be formed by removing the conductive layer 132 through an etch-back process until the top surface of the isolating insulation layer 110 is exposed. According to some embodiments, the plurality of conductive patterns 133 may cover the inner walls of the plurality of first trenches T1 (refer to FIGS. 8A and 8B), respectively. For example, the plurality of conductive patterns 133 may respectively cover side walls of the plurality of mold line patterns 120a spaced apart from each other in the first horizontal direction (X direction) and may extend lengthwise in the second horizontal direction (Y direction).

According to some embodiments, an edge of the upper portion of the plurality of conductive patterns 133 on a side opposite to the mold structure 120 may have a rounded shape. For example, the length of the plurality of conductive patterns 133 in the vertical direction (Z direction) may decrease in a direction receding from a sidewall of the mold structure 120.

According to some embodiments, one sidewall of each of the plurality of conductive patterns 133 may contact the mold structure 120. According to some embodiments, the plurality of conductive patterns 133 may be in contact with the top surface of the isolating insulation layer 110 and may be spaced apart from the plurality of bit lines BL in the vertical direction (Z direction) with the isolating insulation layer 110 therebetween.

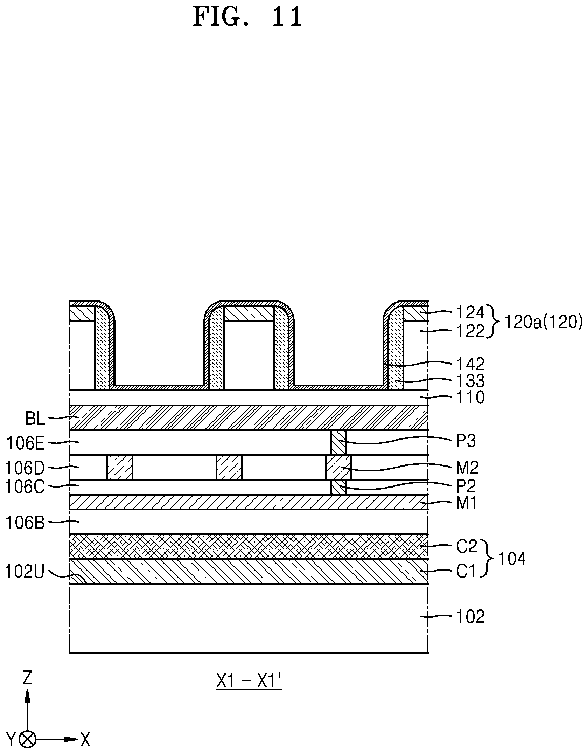

Referring to FIG. 11, a dielectric layer 142 conformally covering a result structure of FIG. 10 may be formed. According to some embodiments, the dielectric layer 142 may cover the mold structure 120, the plurality of conductive patterns 133, and the isolating insulation layer 110. According to some embodiments, a portion of the dielectric layer 142 that covers the plurality of conductive patterns 133 may have a curved shape to correspond to the profile of the sidewalls of the plurality of conductive patterns 133.

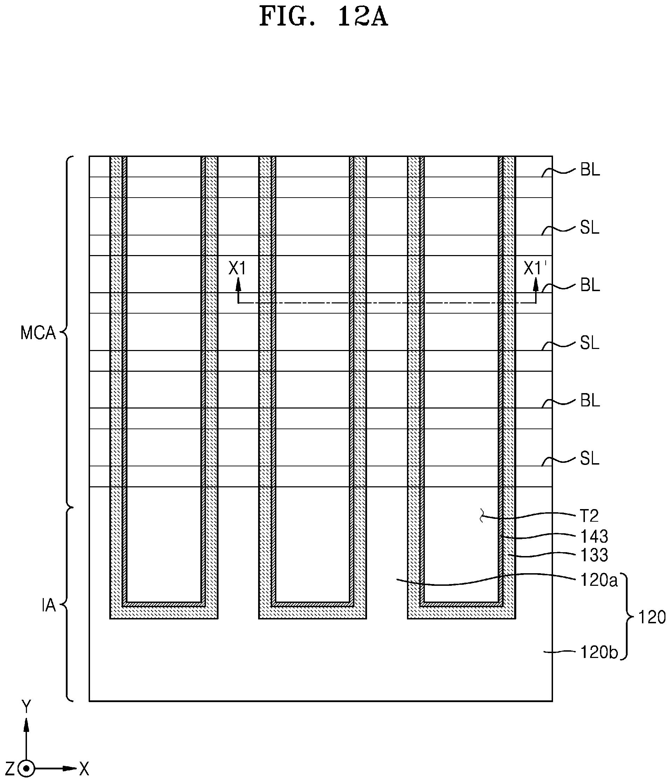

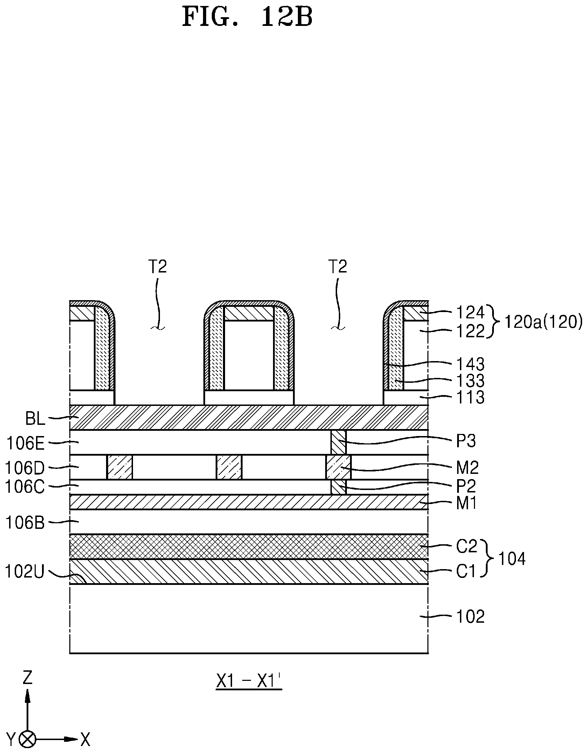

Referring to FIGS. 12A and 12B, in a result structure of FIG. 11, a plurality of second trenches T2 exposing the plurality of bit lines BL may be formed by removing a portion of the dielectric layer 142 and a portion of the isolating insulation layer 110. For example, the second trenches T2 may extend lengthwise in the second horizontal direction (Y direction). According to some embodiments, portions of the dielectric layer 142 that covers the mold structure 120 and the conductive pattern 133 may remain to form a dielectric pattern 143, and a portion of the isolating insulation layer 110 vertically overlapping the dielectric pattern 143 may remain to form a preliminary isolating insulation pattern 113. For example, the dielectric pattern 143, the preliminary isolating insulation pattern 113, the plurality of bit lines BL, and the interlayer insulation layer 106G (refer to FIG. 3C) may define the plurality of second trenches T2. According to some embodiments, the mold structure 120 and the plurality of conductive patterns 133 may be surrounded by the dielectric pattern 143 and the preliminary isolating insulation pattern 113. According to some embodiments, sidewalls of the preliminary isolating insulation pattern 113 may be exposed through the plurality of second trenches T2.

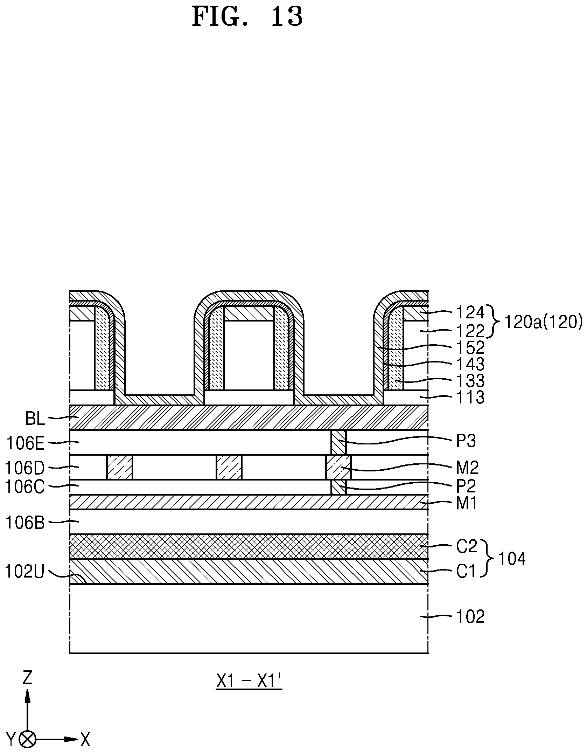

Referring to FIG. 13, a channel film 152 conformally covering a result structure of FIGS. 12A and 12B may be formed. The channel film 152 is formed to cover the top surface of the mold structure 120 and the inner walls and the bottom surfaces of the plurality of second trenches T2 and may cover the plurality of conductive patterns 133, the dielectric pattern 143, and the preliminary isolating insulation pattern 113. According to some embodiments, the channel film 152 may contact the top surfaces of the plurality of bit lines BL, the dielectric pattern 143, and the sidewalls of the preliminary isolating insulation pattern 113. According to some embodiments, a portion of the channel film 152 that covers the plurality of conductive patterns 133 may have a curved shape to correspond to the profile of the sidewalls of the plurality of conductive patterns 133.

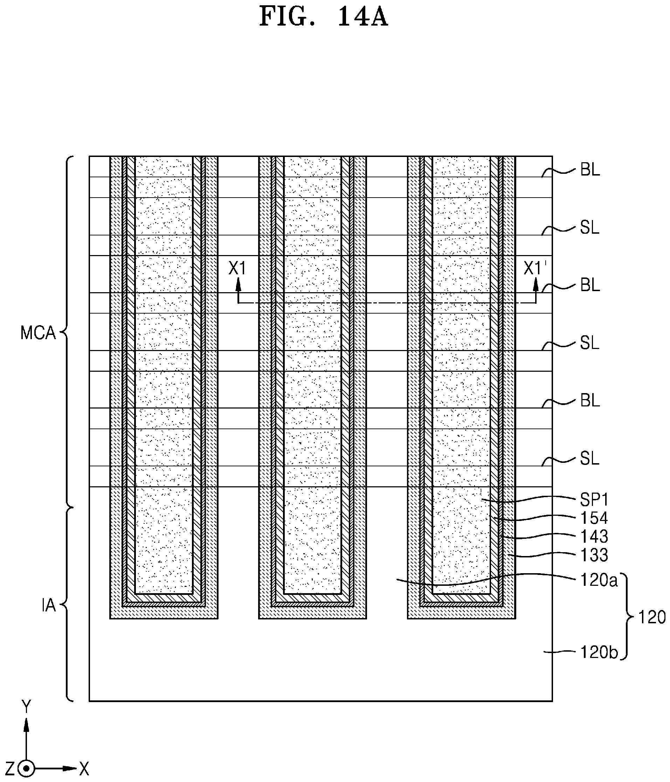

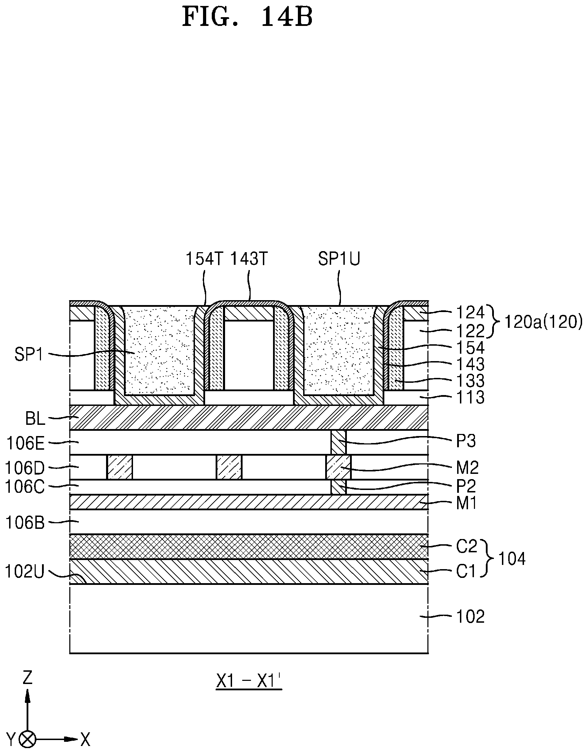

Referring to FIGS. 14A and 14B, a sacrificial film covering a result structure of FIG. 13 may be formed. The sacrificial film may be formed to a sufficient thickness to fill the remaining spaces of the plurality of second trenches T2 (refer to FIGS. 12A and 12B) between the plurality of mold line patterns 120a and to cover the upper portion of the mold structure 120. Thereafter, the sacrificial film may be partially removed through planarization and/or etch-back to form a plurality of first sacrificial patterns SP1. The plurality of first sacrificial patterns SP1 may fill the plurality of second trenches T2 (refer to FIGS. 12A and 12B) on the channel film 152 and extend lengthwise in the second horizontal direction (Y direction), wherein the topmost surface of the plurality of first sacrificial patterns SP1 may be located at a vertical level lower than that of the channel film 152.

According to some embodiments, top surfaces SP1U of the plurality of first sacrificial patterns SP1 may be located at a vertical level lower than that of a topmost surface 143T of the dielectric pattern 143. Therefore, a portion of the channel film 152 covering the topmost surface 143T of the dielectric pattern 143 (e.g., a portion of the channel film 152 located at a vertical level higher than that of the topmost surface 143T of the dielectric pattern 143) may be exposed in a region between the plurality of first sacrificial patterns SP1, e.g., in a plan view. Thereafter, a portion of the channel film 152 may be removed by using the first sacrificial patterns SP1 as an etch mask to form a plurality of preliminary channel structures 154. The dielectric pattern 143 may have an etch selectivity with respect to the channel film 152, and thus the dielectric pattern 143 may not be substantially removed during a main etching process and may be exposed through regions between the plurality of first sacrificial patterns SP1, e.g., in a plan view. According to some embodiments, the plurality of preliminary channel structures 154 may extend parallel to one another in the second horizontal direction (Y direction) within the plurality of second trenches T2 (refer to FIGS. 12A and 12B). According to some embodiments, topmost surfaces 154T of the plurality of preliminary channel structures 154 may be located at a vertical level substantially identical to that of the top surfaces SP1U of the plurality of first sacrificial patterns SP1. For example, a first sacrificial pattern SP1 may be formed as a spin-on hard mask, but the inventive concept is not limited thereto.

According to some embodiments, the top surfaces SP1U of the plurality of first sacrificial patterns SP1 may be located at a vertical level substantially identical to that of topmost surfaces of the plurality of conductive patterns 133. For example, the topmost surface 154T of the plurality of preliminary channel structures 154 may be located at a vertical level lower than that of the topmost surface 143T of the dielectric pattern 143 and substantially identical to that of the top surface of the mold structure 120. In this case, the semiconductor device 100 described with reference to FIGS. 1 to 4B and the semiconductor device 100a described with reference to FIG. 5A may be formed by performing a manufacturing process described later.

According to some embodiments, the top surfaces SP1U of the plurality of first sacrificial patterns SP1 may be located at a vertical level lower than that of topmost surfaces of the plurality of conductive patterns 133. For example, the top surfaces SP1U of the plurality of first sacrificial patterns SP1 may be arranged at a vertical level lower than that of rounded corners of the plurality of conductive patterns 133, and the topmost surfaces 154T of the plurality of preliminary channel structures 154 may be arranged at a vertical level lower than the topmost surface 143T of the dielectric pattern 143. In this case, the semiconductor device 100b described with reference to FIGS. 5B and the semiconductor device 100c described with reference to FIG. 5C may be formed by performing a manufacturing process described later.

According to some embodiments, top surfaces SP1U of the plurality of first sacrificial patterns SP 1 may be located at a vertical level substantially identical to that of a topmost surface 143T of the dielectric pattern 143. For example, the top surfaces SP1U of the plurality of first sacrificial patterns SP1 may be arranged at a vertical level substantially identical to that of the topmost surface 143T of the dielectric pattern 143, and the topmost surfaces 154T of the plurality of preliminary channel structures 154 may be arranged at a vertical level substantially identical to that of the topmost surface 143T of the dielectric pattern 143. In this case, the semiconductor device 100d described with reference to FIG. 5D may be formed by performing a manufacturing process described later.

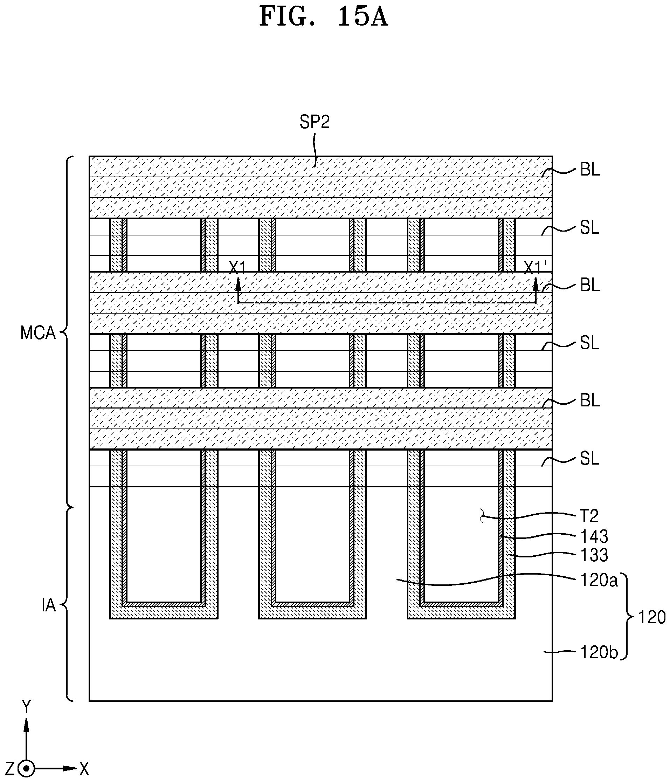

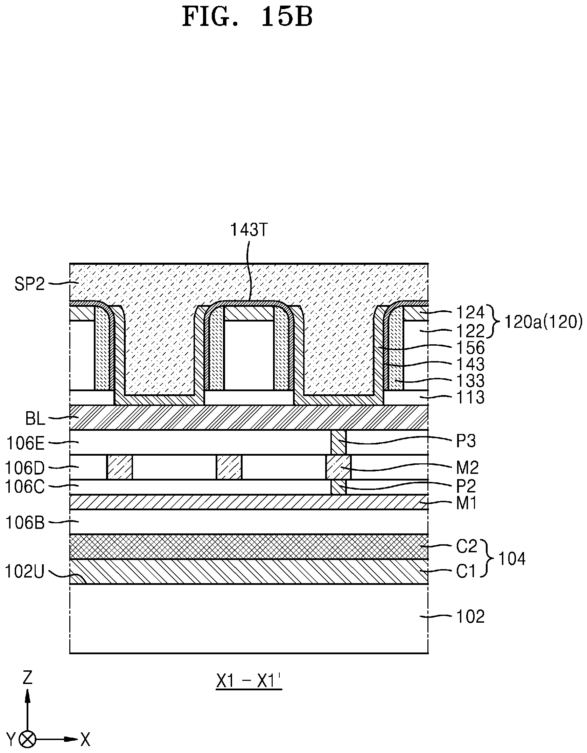

Referring to FIGS. 15A and 15B, in a result structure of FIGS. 14A and 14B, after removing the plurality of first sacrificial patterns SP1, a plurality of second sacrificial patterns SP2 vertically overlapping the plurality of bit lines BL in the cell array region MCA may be formed.

The plurality of second sacrificial patterns SP2 may be formed to cover the top surfaces of the plurality of preliminary channel structures 154 and the top surface of the dielectric pattern 143 and extend lengthwise in the first horizontal direction (X direction). Thereafter, the plurality of channel structures 156 may be formed by partially removing the plurality of preliminary channel structures 154 by using the plurality of second sacrificial patterns SP2 as an etching mask. The dielectric pattern 143 may have an etch selectivity with respect to the channel film 152 and may not be substantially removed during the main etching process by which the channel film 152 is patterned. For example, the plurality of second sacrificial patterns SP2 may be formed as a spin-on hard mask, but the inventive concept is not limited thereto. According to some embodiments, the plurality of preliminary channel structures 154 may be arranged between the plurality of mold line patterns 120a and may be spaced apart from one another in the first horizontal direction (X direction) and the second horizontal direction (Y direction).

According to some embodiments, portions of the plurality of second trenches T2 may be exposed again in a region where the plurality of second sacrificial patterns SP2 are not formed. For example, in a region where the plurality of second sacrificial patterns SP2 are not formed, sidewalls of the dielectric pattern 143 and the preliminary isolating insulation pattern 113 may be exposed. For example, in the interface region IA, sidewalls of the dielectric pattern 143 and the preliminary isolating insulation pattern 113 may be exposed.

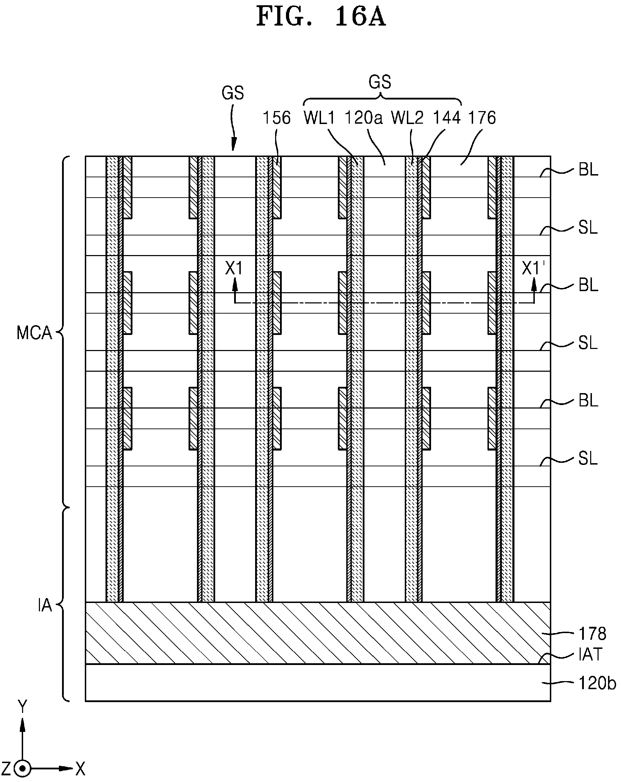

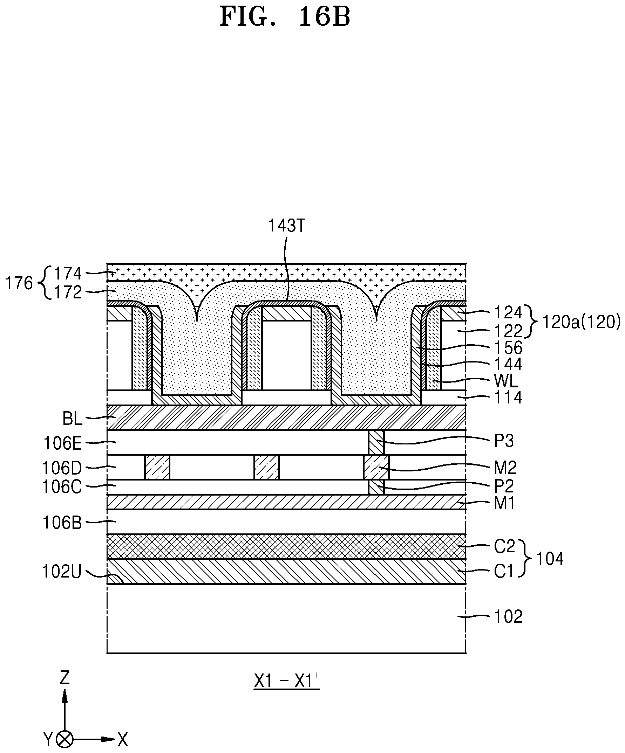

Referring to FIGS. 16A and 16B, in a result structure of FIGS. 15A and 15B, the plurality of second sacrificial patterns SP2 may be removed, the first gap-fill layer 172 and the second gap-fill layer 174 may be sequentially formed, and then the second gap-fill layer 174 may be planarized, thereby forming the gap-fill insulation structure 176. The gap-fill insulation structure 176 may be formed to have a sufficient thickness to fill the remaining portions of the plurality of second trenches T2 and cover the topmost surface 143T of the dielectric pattern 143.

Thereafter, the interface trench IAT extending lengthwise in the first horizontal direction (X direction) may be formed to separate the plurality of mold line patterns 120a and the mold merge pattern 120b from each other in the interface region IA. According to some embodiments, the interface trench IAT may be formed to vertically overlap ends of the plurality of second trenches T2 in the second horizontal direction (Y direction).

Therefore, the preliminary isolating insulation pattern 113 may be divided into the plurality of isolating insulation patterns 114 extending lengthwise in the second horizontal direction (Y direction), and the dielectric pattern 143 may be divided into the plurality of gate dielectric layers 144 extending lengthwise in the second horizontal direction (Y direction). The plurality of conductive patterns 133 may each be separated into two word lines WL arranged to face each other with the gap-fill insulation structure 176 therebetween.

Although not shown, in the interface region IA, the remaining portion of the preliminary isolating insulation pattern 113 other than the plurality of isolating insulation patterns 114 may be disposed on the bottom surface of the mold merge pattern 120b, and the remaining portion of the dielectric pattern 143 other than the plurality of gate dielectric layers 144 may be disposed on the top surface of the mold merge pattern 120b.

Thereafter, the trim pattern 178 filling the interface trench IAT may be formed. For example, the trim pattern 178 may be formed by forming a first insulation layer and a second insulation layer in the interface trench IAT and then planarizing the first insulation layer and the second insulation layer. For example, the top surface of the trim pattern 178 may be coplanar with the top surface of the gap-fill insulation structure 176.

Referring to FIGS. 1 to 5C together with FIGS. 16A and 16B, in the memory cell array region MCA, after forming a second mask pattern (not shown) exposing a portion of the gap-fill insulation structure 176, a plurality of first contact holes CTH1 exposing top surfaces of the facing portions 156b of the plurality of channel structures 156 may be formed by removing a portion of the gap-fill insulation structure 176 by using the second mask pattern (not shown) as an etching mask. The gap-fill insulation structure 176 may be removed through, for example, a dry etching process.

Thereafter, after removing the second mask pattern (not shown), a conductive layer that fills the plurality of first contact holes CTH1 and covers the top surface of the gap-fill insulation structure 176 may be formed. The conductive layer may include or be formed of Ti, TiN, Ta, TaN, Mo, Ru, W, WN, TiSiN, WSiN, or a combination thereof. Thereafter, the plurality of conductive contact patterns 182 may be formed by etching a portion of the conductive layer, and the first interlayer insulation layer 184 filling spaces between the plurality of conductive contact patterns 182 may be formed.

Thereafter, in the interface region IA, after a third mask pattern (not shown) exposing a portion of the gap-fill insulation structure 176 is formed, a plurality of second contact holes CTH2 exposing the plurality of word lines WL may be formed by removing a portion of the gap-fill insulation structure 176 by using the third mask pattern (not shown) as an etching mask. Thereafter, after removing the third mask pattern (not shown), a conductive layer that fills the plurality of second contact holes CTH2 and covers the top surface of the gap-fill insulation structure 176 may be formed, the plurality of word line contact patterns 186 may be formed by etching a portion of the conductive layer, and the second interlayer insulation layer 185 filling spaces between the plurality of word line contact patterns 186 may be formed.

Thereafter, the plurality of upper wiring patterns 194 electrically connected to the plurality of word lines WL may be formed on the plurality of word line contact patterns 186, respectively, and the plurality of storage nodes 192 may be formed on the plurality of conductive contact patterns 182, respectively.

According to some embodiments, the process of forming the plurality of first contact holes CTH1 in the memory cell array region MCA and the process of forming the plurality of second contact holes CTH2 in the interface region IA may be performed separately. According to some embodiments, the process of forming the plurality of conductive contact patterns 182 by filling the plurality of first contact holes CTH1 and the process of forming the plurality of word line contact patterns 186 by filling the plurality of second contact holes CTH2 may be performed separately. According to some other embodiments, the process of forming the plurality of conductive contact patterns 182 by filling the plurality of first contact holes CTH1 and the process of forming the plurality of word line contact patterns 186 by filling the plurality of second contact holes CTH2 may be performed simultaneously.

Even though different figures illustrate variations of exemplary embodiments and different embodiments disclose different features from each other, these figures and embodiments are not necessarily intended to be mutually exclusive from each other. Rather, features depicted in different figures and/or described above in different embodiments can be combined with other features from other figures/embodiments to result in additional variations of embodiments, when taking the figures and related descriptions of embodiments as a whole into consideration. For example, components and/or features of different embodiments described above can be combined with components and/or features of other embodiments interchangeably or additionally to form additional embodiments unless the context clearly indicates otherwise, and the present disclosure includes the additional embodiments.

## Claims

1. A semiconductor device (100) comprising:
a lower conductive line (BL) extending in a first horizontal direction (X) on a substrate (102);
an isolating insulation pattern (114) extending in a second horizontal direction (Y) perpendicular to the first horizontal direction (X) over the lower conductive line (BL);
a mold line pattern (120a) extending in the second horizontal direction (Y) on the isolating insulation pattern (114);
a pair of upper conductive lines (WL1, WL2) each having an inner wall (WLS1) in contact with a corresponding sidewall of the mold line pattern (120a) and a bottom surface in contact with a top surface of the isolating insulation pattern (114) and linearly extending in the second horizontal direction (Y);
a gate dielectric layer (144) covering a top surface of the mold line pattern (120a) and outer walls (WLS2) of the pair of upper conductive lines (WL1, WL2) and linearly extending in the second horizontal direction (Y); and
a channel structure (156) contacting the lower conductive line (BL) and facing a first upper conductive line (WL) from among the pair of upper conductive lines (WL1, WL2) with the gate dielectric layer (144) therebetween.

2. The semiconductor device (100) of claim 1, wherein an inner wall (WLS1) of each of the pair of upper conductive lines (WL1, WL2) extends linearly in a vertical direction (Z), and
an upper portion (UPW) of an outer wall (WLS2) of each of the pair of upper conductive lines (WL1, WL2) has a curved shape that is convex toward the gate dielectric layer (144).

3. The semiconductor device (100) of claim 1 or 2, wherein the channel structure (156) comprises a portion in contact with a sidewall (114S) of the isolating insulation pattern (114).

4. The semiconductor device (100) of any one of claims 1 to 3, further comprising:
a gap-fill insulation structure (176) covering the gate dielectric layer (144) and the channel structure (156); and
a conductive contact pattern (182) penetrating through a portion of the gap-fill insulation structure (176) and contacting a topmost surface (156U) of the channel structure (156).

5. The semiconductor device (100) of claim 4, wherein the conductive contact pattern (182) comprises a portion in contact with a sidewall (156S2) of the channel structure (156).

6. The semiconductor device (100) of claim 4 or 5, wherein a bottommost surface (182B2) of the conductive contact pattern (182) is disposed at a vertical level (LV2) identical to or lower than a vertical level (LV1) of a topmost surface (WLT) of the first upper conductive line (WL).

7. The semiconductor device (100) of any one of claims 4 to 6, wherein the topmost surface (156U) of the channel structure (156) is disposed at a vertical level (LV1) substantially identical to a vertical level (LV1) of the topmost surface (WLT) of the first upper conductive line (WL).

8. The semiconductor device (100) of any one of claims 1 to 3, further comprising:
a gap-fill insulation structure (176) covering the gate dielectric layer (144) and the channel structure (156); and
a word line contact pattern (186) spaced apart from the channel structure (156) in the second horizontal direction (Y) in a plan view and penetrating through a portion of the gap-fill insulation structure (176) to contact the first upper conductive line (WL).

9. The semiconductor device (100) of any one of claims 1 to 8, wherein an upper portion (UPW) of an outer wall (WLS2) of the first upper conductive line (WL) has a curved shape convex toward the gate dielectric layer (144),
the channel structure (156) has a curved shape to correspond to the upper portion (UPW) of the outer wall (WLS2) of the first upper conductive line (WL), and
the topmost surface (156U) of the channel structure (156) is parallel to a top surface (102U) of the substrate (102).

10. The semiconductor device (100) of any one of claims 1 to 9, wherein the channel structure (156) comprises IGZO, InGaZnO, Sn-IGZO, IWO, InWO, IZO, InZnO, ZTO, ZnSnO, ZnO, YZO, yttrium-doped zinc oxide, IGSO, InGaSiO, InO, SnO, TiO, ZnON, MgZnO, ZrInZnO, HflnZnO, SnInZnO, SiInZnO, GaZnSnO, ZrZnSnO, Si, Ge, SiGe, a Group III-V compound semiconductor, or a combination thereof.

11. A semiconductor device (100) comprising:
a plurality of bit lines (BL) extending lengthwise in a first horizontal direction (X) and spaced apart from each other in a second horizontal direction (Y) perpendicular to the first horizontal direction (X);
a plurality of isolating insulation patterns (114) extending lengthwise in the second horizontal direction (Y) on the plurality of bit lines (BL) and spaced apart from each other in the first horizontal direction (X);
a plurality of gate composite structures (GCS) extending parallel to each other in the second horizontal direction (Y) on the plurality of isolating insulation patterns (114) and each comprising:
a mold structure (120) extending in the second horizontal direction (Y);
a first word line (WL1) and a second word line (WL2) respectively covering side walls of the mold structure (120) opposite each other in the first horizontal direction (X) and extending in the second horizontal direction (Y); and
a gate dielectric layer (144) covering the mold structure (120), the first word line (WL1), and the second word line (WL2);
a plurality of channel structures (156) spaced apart from each other in the second horizontal direction (Y) between a first gate composite structure (GCS) and a second gate composite structure (GCS) adjacent to each other from among the plurality of gate composite structures (GCS), each contacting one bit line (BL) from among the plurality of bit lines (BL), and respectively facing the second word line (WL2) of the first gate composite structure (GCS) and the first word line (WL1) of the second gate composite structure (GCS); and
a gap-fill insulation structure (176) that fills a space between the first gate composite structure (GCS) and the second gate composite structure (GCS) and covers the first gate composite structure (GCS), the second gate composite structure (GCS), and the plurality of channel structures (156),
wherein each of the first word line (WL1) and the second word line (WL2) includes an inner wall (WLS1) in contact with the mold structure (120) and an outer wall (WLS2) in contact with the gate dielectric layer (144), and
an upper portion (UPW) of the outer wall (WLS2) has a curved shape convex toward the gate dielectric layer (144).

12. The semiconductor device (100) of claim 11, wherein a vertical cross-section of the gate dielectric layer (144) in the first horizontal direction (X) has a vertically inverted 'U' shape.

13. The semiconductor device (100) of claim 11 or 12, wherein each of the plurality of channel structures (156) comprises:
a bottom portion (156a) in contact with a top surface of the one bit line (BL);
a first facing portion (156b) vertically extending from one end of the bottom portion (156a) in the first horizontal direction (X) and facing the second word line (WL2) of the first gate composite structure (GCS) with the gate dielectric layer (144) of the first gate composite structure (GCS) therebetween; and
a second facing portion (156b) vertically extending from another end of the bottom portion (156a) in the first horizontal direction (X) and facing the first word line (WL1) of the second gate composite structure (GCS) with the gate dielectric layer (144) of the second gate composite structure (GCS) therebetween.

14. The semiconductor device (100) of claim 13, wherein the bottom portion (156a) vertically overlaps the gap-fill insulation structure (176), and
the first facing portion (156b) is spaced apart from the second facing portion (156b) in the first horizontal direction (X) with the gap-fill insulation structure (176) therebetween.

15. The semiconductor device (100) of any one of claims 11 to 14, wherein bottom surfaces of the first word line (WL1) and the second word line (WL2) and a bottom surface of the gate dielectric layer (144) are arranged on a same plane.
